# EUROPEAN PATENT APPLICATION

(11) **EP 3 815 926 A1**
(43) Date of publication of application: **05.05.2021**
(21) Application number: 19808407.1
(22) Date of filing: 25.04.2019
(51) Int. Cl.: B44C 1/17, B32B 37/02, H05K 3/20, H05K 3/24

(54) **PATTERN-TRANSFERRED OBJECT MANUFACTURING METHOD**

(30) Priority: 25.05.2018 JP 2018100299; 25.05.2018 JP 2018100300; 25.05.2018 JP 2018100301; 29.06.2018 JP 2018124520; 03.07.2018 JP 2018126829; 12.07.2018 JP 2018131961; 24.07.2018 JP 2018138334; 08.08.2018 JP 2018149372; 08.08.2018 JP 2018149474; 22.08.2018 JP 2018155255; 30.08.2018 JP 2018161856; 30.08.2018 JP 2018161857; 13.09.2018 JP 2018171163; 13.09.2018 JP 2018171164; 26.03.2019 JP 2019059100
(71) Applicant: Mitsubishi Paper Mills Limited, Tokyo 130-0026 (JP)
(72) Inventor: SHINO, Shigeki, Tokyo 130-0026 (JP); GOKAN, Norihiko, Tokyo 130-0026 (JP); TOKUNAGA, Yukio, Tokyo 130-0026 (JP)
(74) Representative: Cabinet Beau de Loménie
(86) International application number: PCT/JP2019/017631
(87) International publication number: WO 2019/225286

(57) **Abstract**

The present invention aims to provide a method of producing a pattern-transferred product with simple steps, the method being capable of producing a pattern-transferred product having good adhesion between a transferred pattern and the transfer-receiving body. The method of producing a pattern-transferred product of the present invention includes a step of forming a transfer pattern on a dissociation layer of a transfer sheet including at least a porous layer on a support and the dissociation layer on the porous layer; a transferring step, the step being selected from a step of transferring the transfer pattern to a transfer-receiving body having an adhesive surface or a step of transferring the transfer pattern to a transfer-receiving body via an adhesive material; and a step of removing adhesion from the surface of the transfer-receiving body or from the adhesive material.

## Description

### TECHNICAL FIELD

The present invention relates to a method of producing a pattern-transferred product by transferring a transfer pattern formed on a transfer sheet, from the transfer sheet to a transfer-receiving body.

### BACKGROUND ART

Recent advances in miniaturization and high performance of electronic devices have created strong demand for formation of microwires of conductive materials used in such electronic devices and for reduction in coefficient of thermal expansion of such conductive materials. One known means to reduce the coefficient of thermal expansion of an insulating material constituting a conductive material is a method of providing a highly filled insulating material, i.e., a method of increasing the amount of an inorganic filler in the insulating material. It has been also suggested to use an alkali-insoluble resin having excellent moisture resistance, such as an epoxy resin, a phenol novolac curing agent, a phenoxy resin, or a cyanate resin, as an insulating material. An insulating resin composition containing such an inorganic filler and an alkali-insoluble resin has excellent physical properties in terms of heat resistance, dielectric properties, mechanical strength, chemical resistance, and the like, and is thus widely used as a component of conductive materials, such as a solder resist used in outer layer surfaces of conductive materials or an interlayer insulating material used in multilayer build-up wiring boards.

One known conductive material including an interlayer insulating material is a conductive material laminate produced by forming an adhesive insulating resin layer as an interlayer insulating material on a surface of a conventional conductive material and forming a conductive pattern on a surface of the adhesive insulating resin layer.

One known method of forming a conductive pattern on a surface of an adhesive insulating resin layer is a method using photolithography. One known example is a subtractive method including forming a metal layer on an adhesive insulating resin layer, providing a photoresist layer on the metal layer to form a resist pattern, and removing the metal layer by etching. However, the steps of the method using photolithography are complicated. Thus, there is a demand for a method of easily forming a conductive pattern on an adhesive insulating resin layer.

One known method of easily forming a conductive pattern on an adhesive insulating resin layer is a method of printing an ink containing conductive particles on an adhesive insulating resin layer. For example, Patent Literature 1 discloses such a method of screen printing a conductive paste on an adhesive insulating resin layer and curing the conductive paste to form a conductive pattern on the adhesive insulating resin layer. However, the method of screen printing a conductive paste on the adhesive insulating resin layer sometimes results in insufficient adhesion between the adhesive insulating resin layer and the conductive pattern after curing.

One known method of forming a conductive pattern on a target object is a method of transferring a conductive pattern to a target object by forming a conductive pattern on a transfer sheet by an inkjet printer and thermally pressure-bonding the transfer sheet to a surface of the target object (transfer-receiving body). One example of the transfer sheet used in such a method is an ink-receiving layer transfer sheet for inkjet recording disclosed in Patent Literature 2, which includes an ink-receiving layer on a film as a substrate and an adhesive layer on the ink-receiving layer, wherein the ink-receiving layer contains inorganic particles having an average particle size of 300 nm or less and a binder in an amount of 5 to 50 mass% relative to the inorganic particles, and the adhesive layer is made of a thermoplastic resin having a glass-transition temperature of 0°C to 50°C. When the transfer sheet disclosed in Patent Literature 2 is used to form a conductive pattern on an adhesive insulating resin layer of a conductive material, it is possible to improve the adhesion between the adhesive insulating resin layer and the conductive pattern because the conductive pattern is thermally pressure-bonded to the adhesive insulating resin layer during transfer. However, when the transfer sheet disclosed in Patent Literature 2 is used to form a conductive pattern on a conductive material, the ink-receiving layer is also transferred with the conductive pattern to the conductive material during transfer. Thus, a surface of the conductive pattern is covered with the transferred ink-receiving layer, with the result that the conductive pattern cannot be electrically connected to other conductive members, making it difficult to use the resulting member as a conductive material.

Other methods that have been studied include a method of producing a conductive material by transferring a conductive pattern to a transfer-receiving body. For example, Patent Literature 3 discloses a wiring circuit member obtained by transferring a wiring circuit of a transfer wiring circuit board to at least one surface of a transfer-receiving body via an adhesive layer, wherein the wiring circuit of the transfer wiring circuit board is made of wires having a width of 200 µm or less which is formed by printing a dispersion containing conductive metal particles having an average particle size of 1 to 100 nm on a releasable, heat-resistant substrate by an inkjet recording method, and firing the dispersion. However, since the releasable, heat-resistant substrate does not include an ink-receiving layer, cissing easily occurs during printing of the dispersion, making it difficult to form a conductive pattern.

Patent Literature 4 discloses a method of developing conductivity by allowing ultrafine metal particles and a compound having ionically bonded halogen atoms in the molecule to act on each other to achieve conductivity on a substrate. Patent Literature 4 also discloses a substrate including, as an ink-receiving layer, a porous layer made of inorganic fine particles and a binder in an amount of 80 mass% or less relative to the inorganic fine particles. However, when the substrate is used as a transfer sheet in an attempt to transfer a conductive pattern to a transfer-receiving body including an adhesive layer defining an adhesive surface, the adhesive is adsorbed on the porous layer and is very strongly adhered thereto, so that the adhesive layer cannot be peeled off from the porous layer, or the porous layer is bonded to the adhesive layer that was peeled off, making it impossible to successfully transfer the conductive pattern from the substrate to the transfer-receiving body.

Patent Literature 5 discloses a method of producing a conductive pattern, the method including forming a conductive pattern with an ink or paste containing fine metal particles on a substrate; and transferring the conductive pattern to an adhesive surface of a transfer-receiving body including an adhesive layer on a support, wherein the substrate includes a porous layer on a support and a layer mainly containing colloidal silica on the porous layer, and the porous layer is provided to absorb and remove solvent components such as water or organic solvents contained in the ink or paste containing fine metal particles. However, a further improvement is required in the adhesion between the conductive pattern obtained by this method and the transfer-receiving body.

Recently, there have been significant advances in automobiles, portable electronic devices, and the like, and there has been an increasing demand for light weight, thin profile, and high strength. In response, studies have been made on methods of using, as a frame, a molded product of a carbon fiber reinforced resin or a glass fiber reinforced resin obtained by allowing carbon fiber or glass fiber to be impregnated with a thermosetting resin such as an epoxy resin, a phenolic resin, or an unsaturated polyester resin in and thermally curing the resin.

Studies have also been made on providing a plating layer to such a frame produced as described above in order to increase the wear resistance and the corrosion resistance, and on forming a conductive metal layer or a conductive pattern of a touch sensor or antenna on the frame to provide a composite product that can be used as a conductive member. One example of the former is a method disclosed in Patent Literature 6. In this method, a metal layer is formed by plating on a surface of a carbon-fiber-reinforced resin molded product by applying low-temperature plasma to the surface. However, this method requires an expensive manufacturing device, and is complicated with many steps because plating is involved.

It is possible to produce a conductive member by attaching, to a frame, a transfer-receiving body to which the conductive pattern disclosed in Patent Literature 5 has been transferred, but a further improvement is required in the adhesion between the conductive pattern and the frame. Further, the transfer-receiving body has a thickness that is at least several micrometers to tens of micrometers, and an adhesive layer is exposed at a non-image portion to which no pattern is transferred, so that the frame and the pattern failed to achieve a sense of unity, presenting a new problem.

One known method of obtaining a metallic decorative member by forming a metallic pattern on a transfer-receiving body is hot stamping in which a metal foil is transferred to a surface of the transfer-receiving body. Hot stamping is a method in which a metal foil having an adhesive layer sheet is placed on a surface of a transfer-receiving body, a pressure is applied from above with a heated die to break the metal foil along the die, and the metal foil in the pattern of the die is transferred to the transfer-receiving body using the adhesive layer of the metal foil. However, hot stamping that involves pressing using a die requires production of a different die for each pattern design. Thus, the production cost is high.

Thus, Patent Literature 7, for example, discloses a method using a thermal head instead of a die, in which a metal deposition layer in a desired pattern is first transferred from a metal deposition transfer sheet to a transfer foil, and the metal deposition layer is transferred from the transfer foil to a transfer-receiving body, whereby the method produces a metallic decorative member without needing a die. However, the method requires the transfer foil as an intermediate material and is complicated with many steps.

Patent Literature 8, for example, discloses a method in which a metal foil is adhered to a surface of a transfer-receiving body, a resist layer is formed in a desired pattern by UV inkjet printing on the metal foil, and the resist is removed after etching, whereby the method produces a metallic decorative member without needing a die. However, the method involves etching and resist removal, and is thus complicated with many steps.

Patent Literature 9, for example, discloses a method in which a decoration ink containing silver β-ketocarboxylate is printed on a transfer-receiving body by an inkjet method or using a dispenser, and the silver β-ketocarboxylate is then decomposed into metal silver by heating, whereby the method produces a metallic decorative member without needing a die. However, blurring of the decoration ink occurs when the transfer-receiving body is impermeable, and an undercoat layer is prerequisite when the transfer-receiving body is permeable.

A transfer-receiving body to which the conductive pattern disclosed in Patent Literature 5 has been transferred can be used as a metallic decorative member, but a further improvement is required in the adhesion between the metallic pattern and the transfer-receiving body.

Recently, various high-definition printing techniques have been developed, and many high-definition prints have been produced and made commercially available. An increase in requirements to obtain unique prints on-demand has increased the need for high-definition printing with coloring materials such as pigments and dyes not only on conventional paper media but also on various objects including fiber materials such as fabric, synthetic leather, resin molded products, metal molded products, and wood processed products. Under such a circumstance, for example, the following methods are used for such applications: sublimation ink print transfer, in which transfer paper printed with a sublimation ink is used for thermal sublimation transfer to a target object; water-based pigment ink direct printing, in which a water-based pigment ink is directly printed on a target object; UV inkjet printing, in which a UV curable ink is used to be directly printed on a target object; screen printing; and the like.

However, in the case of sublimation ink print transfer or water-based pigment ink direct printing, some target objects need to include a fixing layer (absorption layer) for holding the sublimation ink or the water-based pigment ink. In the case of direct printing by water-based pigment ink direct printing on fabric or the like capable of holding an ink, post-washing is required in some cases in order to remove unwanted components of the printed ink. In the case of UV inkjet printing, while printing can be performed on relatively many kinds of target objects, the printing generates a strong odor probably from residual monomer components of a UV curable ink, which often causes problems. In the case of screen printing, the odor is not as strong as that generated in UV inkjet printing. However, the curing of an ink used takes time in some cases, and when printing is performed on fabric or the like, post-washing is required in some cases in order to remove unwanted residual components of the ink.

In response to these problems, a method has been used in which an image pattern is formed and held in advance on a transfer sheet, and the image pattern is transferred to a transfer-receiving body. For example, as described in Patent Literature 2, a method has been used in which a pattern is formed with a coloring material on a transfer sheet by an inkjet printer, and the transfer sheet is then thermally pressure-bonded to a surface of a transfer-receiving body, whereby the pattern is transferred to the transfer-receiving body. However, in this method, the ink-receiving layer is also transferred with the pattern to the transfer-receiving body, thus failing to produce a high-definition patten with high color development in some cases.

Use of the transfer method disclosed in Patent Literature 5 for such an application eliminates the problems such as transfer of unwanted solvent components and/or unwanted porous layer to a transfer-receiving body. However, a pattern is transferred with a coloring material to a transfer-receiving body having an adhesive layer, so that in some cases, the adhesion between the pattern and the transfer-receiving body is poor and the pattern comes off.

### CITATION LIST

### - Patent Literature

Patent Literature 1: JP H11-150150 A
Patent Literature 2: JP 2007-313847 A
Patent Literature 3: JP 2010-135692 A
Patent Literature 4: JP 2008-4375 A
Patent Literature 5: JP 2014-192275 A
Patent Literature 6: JP H06-264250 A
Patent Literature 7: JP 2011-93296 A
Patent Literature 8: JP 2016-175305 A
Patent Literature 9: JP 2017-87483 A

### SUMMARY OF INVENTION

### - Technical Problem

The present invention aims to provide a method of producing a pattern-transferred product with simple steps, the method being capable of producing a pattern-transferred product having good adhesion between a transferred pattern and a transfer-receiving body.

### - Solution to Problem

The object of the present invention is essentially achieved by the following inventions.
1. A method of producing a pattern-transferred product, including: a step of forming a transfer pattern on a dissociation layer of a transfer sheet including at least a porous layer on a support and the dissociation layer on the porous layer; a transferring step, the step being selected from a step of transferring the transfer pattern to a transfer-receiving body having an adhesive surface or a step of transferring the transfer pattern to a transfer-receiving body via an adhesive material; and a step of removing adhesion from the surface of the transfer-receiving body or from the adhesive material.
2. The method of producing the pattern-transferred product according to 1, wherein the transfer-receiving body having an adhesive surface is a transfer-receiving body that is adhesive at room temperature, and the step of removing adhesion from the surface of the transfer-receiving body is a step of thermally curing the transfer-receiving body.
3. The method of producing a pattern-transferred product according to 1, wherein the transfer-receiving body having an adhesive surface is a transfer-receiving body that is not adhesive at room temperature and that becomes adhesive when heated, and the step of removing adhesion from the surface of the transfer-receiving body is a step of thermally curing the transfer-receiving body.
4. The method of producing a pattern-transferred product according to 1, wherein the transfer-receiving body having an adhesive surface is a transfer-receiving body that is not adhesive at room temperature and that becomes adhesive when heated, and the step of removing adhesion from the surface of the transfer-receiving body is a step of naturally cooling the transfer-receiving body to room temperature.
5. The method of producing a pattern-transferred product according to 1, wherein the adhesive material is a material that is not adhesive at room temperature and that becomes adhesive when heated, and the step of removing adhesion from the adhesive material is a step of naturally cooling the transfer-receiving body to room temperature.
6. The method of producing a pattern-transferred product according to any one of 1 to 5, wherein the transfer pattern is a pattern selected from a conductive pattern, a metallic pattern, or a pattern printed with pigment inks.
7. The method of producing a pattern-transferred product according to 2 or 3, wherein the transfer pattern is a conductive pattern, and the method includes, after the transferring step, a step of plating the transferred conductive pattern, and subsequently includes the step of removing adhesion from the surface of the transfer-receiving body.
8. The method of producing a pattern-transferred product according to 4, wherein the transfer pattern is a conductive pattern, and the method includes, after the step of removing adhesion from the surface of the transfer-receiving body, a step of plating the transferred conductive pattern.
9. The method of producing a pattern-transferred product according to any one of 1 to 8, wherein the porous layer contains at least one compound selected from glycerol or polyglycerol.

### - Advantageous Effects of Invention

The present invention can provide a method of producing a pattern-transferred product with simple steps, the method being capable of producing a pattern-transferred product having good adhesion between a transferred pattern and a transfer-receiving body.

### BRIEF DESCRIPTION OF DRAWINGS

Fig. 1 is a schematic cross-sectional view of a transfer sheet on which a transfer pattern is formed according to the present invention.
Fig. 2 is a schematic cross-sectional view of the transfer sheet on which a transfer pattern is formed, with a transfer-receiving body attached thereto, according to the present invention.
Fig. 3 is a schematic cross-sectional view of a pattern-transferred product according to the present invention.
Fig. 4 is another schematic cross-sectional view of the pattern-transferred product according to the present invention.
Fig. 5 is a schematic cross-sectional view of the transfer sheet on which a transfer pattern is formed, with a transfer-receiving body attached thereto via a material that is not adhesive at room temperature and that becomes adhesive when heated, according to the present invention.
Fig. 6 is a schematic cross-sectional view of a pattern-transferred product produced by transferring a pattern thereto via a material that is not adhesive at room temperature and that becomes adhesive when heated, according to the present invention.
Fig. 7 is a schematic cross-sectional view of a pattern-transferred product including a plating layer on a conductive pattern according to the present invention.

### DESCRIPTION OF EMBODIMENTS

The present invention is described in detail below.

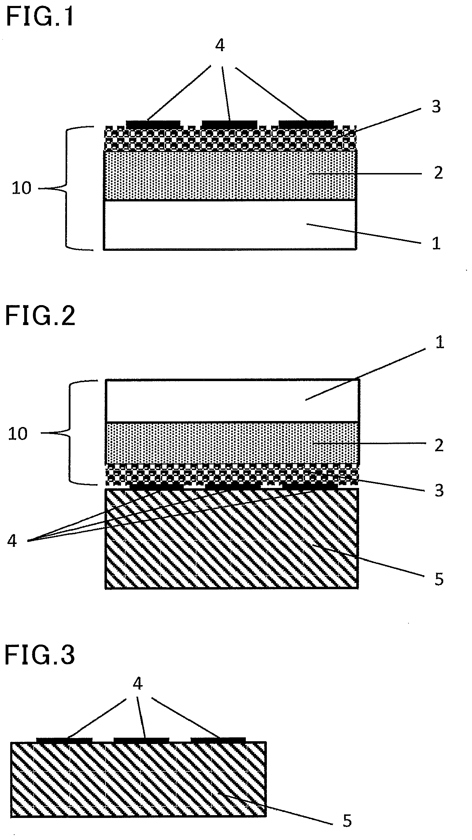

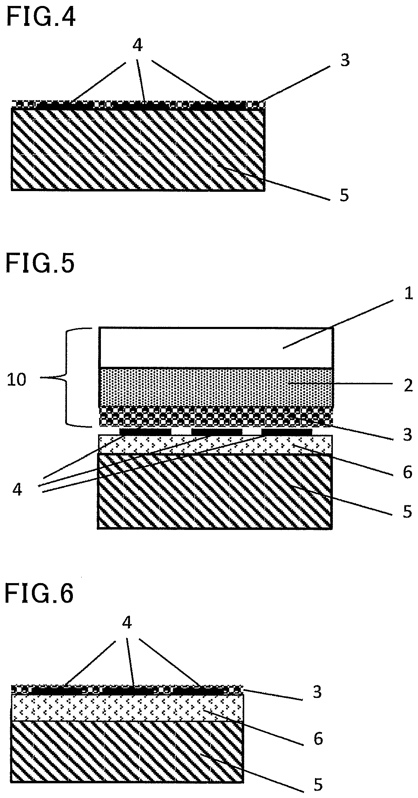

A method of producing a pattern-transferred product of the present invention is described with reference to the drawings. First, a transfer sheet 10 including a porous layer 2 and a dissociation layer 3 on the support 1 is provided (Fig. 1). Next, a transfer pattern 4 is formed on the dissociation layer 3 of the transfer sheet 10 by printing using an inkjet printer or the like (Fig. 1). Subsequently, a transfer pattern 4-formed surface of the transfer sheet 10 is attached to a transfer-receiving body 5 whose surface is adhesive at room temperature or which is heated to a temperature at which its surface becomes adhesive (Fig. 2). Then, after an optional step of naturally cooling to room temperature, the transfer sheet 10 attached to the transfer-receiving body 5 is removed therefrom. When the transfer-receiving body 5 exhibits an adhesive force at room temperature, the transfer-receiving body 5 is further thermally cured, thus producing a pattern-transferred product of the present invention as in the transfer-receiving body 5 to which the transfer pattern 4 is transferred (Fig. 3 or Fig. 4).

Alternatively, the transfer pattern 4-formed surface of the transfer sheet 10 obtained as described above is attached to the transfer-receiving body 5 via a material 6 that is not adhesive at room temperature and that becomes adhesive when heated, by heating to a temperature at which the material 6 becomes adhesive (Fig. 5). Then, after the step of naturally cooling to room temperature, the transfer sheet 10 attached to the transfer-receiving body 5 is removed therefrom, thus producing a pattern-transferred product of the present invention as in the transfer-receiving body 5 to which the transfer pattern 4 is transferred (Fig. 6). The present invention may switch the order between the step of removing adhesion from the surface of the transfer-receiving body by thermal curing or naturally cooling and the step of removing the attached transfer sheet from the transfer-receiving body.

The transfer sheet in the present invention is a substrate including at least a porous layer on a support and a dissociation layer on the porous layer. The transfer sheet in the present invention is used for temporarily holding a transfer pattern on the dissociation layer and for transferring the transfer pattern to a transfer-receiving body having an adhesive surface or to a transfer-receiving body via an adhesive material. The porous layer and the dissociation layer may be provided on both sides of the support, if necessary.

Non-limiting examples of the support of the transfer sheet include various types of films, various types of glass, paper, non-woven fabrics, fabrics, various types of metals, and various types of ceramics. Examples of the films include those made of various types of resins, such as polyolefin resins (e.g., polyethylene and polypropylene), polyvinyl chloride resins (e.g., polyvinyl chloride and vinyl chloride copolymers), polyester resins (e.g., polyethylene terephthalate and polyethylene naphthalate), epoxy resin, polyarylate, polysulfone, polyether sulfone, fluororesin, phenoxy resin, triacetyl cellulose, polyimide, polyphenylene sulfide, and polycarbonate), acrylic resins (e.g., polymethylmethacrylate), cellophane, nylon, polystyrene resin, and ABS resin. Examples of the glass include quartz glass, alkali free glass, transparent crystallized glass, and Pyrex®. These supports may be combined, if necessary, depending on use. For example, polyolefin resin-coated paper obtained by laminating pieces of paper with a polyolefin resin can be used.

Preferred among these are paper, polyolefin resin-coated paper, and films made of polyolefin resin, triacetyl cellulose, polyethylene terephthalate, or polycarbonate, in terms of cost and versatility.

When the support is a non-absorbent support among the supports described above, such as a film made of various resins, glass, or polyolefin resin-coated paper, a known undercoat layer made of gelatin, various kinds of urethane resins, polyvinyl alcohols, or the like is preferably provided between the support and the porous layer in order to improve the adhesion between the non-absorbent support and the porous layer. Alternatively, for example, a polyethylene terephthalate film including an undercoat layer, which is commercially available as an easy-adhesion treated product, may be used. It is also preferred to improve the wettability of the support by corona or plasma treatment.

The coating amount based on the solid content of the undercoat layer is preferably 0.5 g/m² or less, more preferably 0.3 g/m² or less, still more preferably 0.1 g/m² or less. A preferred lower limit is 0.01 g/m² or more.

The porous layer of the transfer sheet in the present invention functions to absorb solvent components such as water or organic solvents contained in an ink or paste (described later) suitably used to form a transfer pattern, such as an ink or paste containing conductive fine particles and an ink containing a pigment.

Preferably, the porous layer of the transfer sheet in the present invention is a layer mainly containing fine particles, in terms of absorption of solvent components of an ink or the like used for transfer pattern formation. The expression "mainly containing fine particles" means that the percentage of the fine particles in the total solid content of the porous layer is 50 mass% or more, preferably 70 mass% or more. The fine particles can be selected from various known fine particles. Examples include inorganic fine particles of light calcium carbonate, heavy calcium carbonate, magnesium carbonate, kaolin, talc, calcium sulfate, barium sulfate, titanium dioxide, zinc oxide, zinc sulfide, zinc carbonate, satin white, aluminum silicate, diatomaceous earth, calcium silicate, magnesium silicate, amorphous synthetic silica, alumina, colloidal alumina, alumina hydrate, lithopone, zeolite, hydrated halloysite, magnesium hydroxide, and the like; and organic fine particles of acrylic resin, polyvinyl chloride resin, polyvinyl acetate resin, polyester resin, styrene/acrylic copolymers, styrene/butadiene copolymers, styrene/isoprene copolymers, polycarbonate, silicone resin, urea resin, melamine resin, epoxy resin, phenolic resin, diallyl phthalate resin, and the like. The organic fine particles may be spherical or irregular, non-porous or porous organic fine particles of at least one of the resins described above, for example. The fine particles may be a combination of two or more of the inorganic fine particles described above, a combination of two or more of the organic fine particles described above, or a combination of one or more inorganic fine particles and one or more organic fine particles described above. Preferred among those described above are inorganic fine particles; more preferred are light calcium carbonate, heavy calcium carbonate, kaolin, talc, magnesium carbonate, amorphous synthetic silica, alumina, and alumina hydrate; and particularly preferred are amorphous synthetic silica, alumina, and alumina hydrate, in terms of absorption of solvent components. Alumina hydrate is particularly preferably used when flexibility is required for the transfer sheet in the present invention, such as when the transfer-receiving body has a curved surface.

Amorphous synthetic silica can be roughly classified into wet-process silica, fumed silica, and silica of other types according to the production method.

The wet-process silica is further classified into precipitation-process silica, gel-process silica, and sol-process silica according to the production method. The precipitation-process silica is produced by reaction of sodium silicate with sulfuric acid under alkaline conditions. Grown silica particles are aggregated, deposited, and processed through filtration, washing with water, drying, grinding, and classification to obtain a commercial product. Examples of the precipitation-process silica include commercial products such as Nipsil® from Tosoh Silica Corporation, Tokusil® and Finesil® from Maruo Calcium Co., Ltd., and Mizukasil® from Mizusawa Industrial Chemicals, Ltd. The gel-process silica is produced by reaction of sodium silicate with sulfuric acid under acidic conditions. During maturing, fine particles are dissolved and reprecipitated, forming bonds between other primary particles. Thus, clear primary particles disappear, and relatively hard particle aggregates having a hollow structure are formed. Examples of gel-process silica include commercial products such as NIPGEL® from Tosoh Silica Corporation, SYLOID® and SYLOJET® from GCP Japan, and MIZUKASIL from Mizusawa Industrial Chemicals, Ltd. In the present invention, the precipitation-process silica or gel-process silica is preferred, and the precipitation-process silica is more preferred.

The particle properties of the wet-process silica are as follows: the average primary particle size is 50 nm or less, preferably 3 to 40 nm; and the average aggregate particle size is preferably 1 to 50 µm. More preferably, wet-process silica particles having an average aggregate particle size of 5 to 50 µm are dispersed to obtain an average secondary particle size of 500 nm or less. The average secondary particle size of the dispersed wet-process silica is more preferably 10 to 300 nm, still more preferably 20 to 200 nm. The dispersion method is preferably a wet dispersion method that mechanically grinds wet-process silica mixed with a water-based medium. Preferably, a media mill such as a bead mill is used in this method. In the bead mill, beads and a pigment placed in a sealed vessel are collided with each other, whereby the pigment is ground. Examples include commercial products such as Dyno-Mill from Willy A. Bachofen AG, GRAIN MILL® from Asada Iron Works. Co., Ltd., and Star Mill® from Ashizawa Finetech Ltd. After dispersion in a media mill or the like, the wet-process silica is preferably further dispersed in a pressure type disperser such as a high-pressure homogenizer or an ultrahigh-pressure homogenizer, an ultrasonic wave disperser, a thin-film spin disperser, or the like.

The phrase "average primary particle size of the fine particles" as used herein is an average particle size determined by electron microscopic observation of the fine particles, with the particle size being the diameter of a circle equivalent to a projected area of each of 100 primary particles present in a certain area. The average secondary particle size of the fine particles can also be determined by electron microscopic observation, but it can be simply measured as the number median diameter using, for example, a laser scattering particle size distribution analyzer (e.g., LA910 from Horiba, Ltd.). The average aggregate particle size of the wet-process silica is the average particle size of the silica in the powder form, and can be determined by the Coulter counter method, for example.

The fumed silica is also referred to as dry-process silica as opposed to the wet-process silica, and it is generally prepared by a flame hydrolysis method. Specifically, a production method in which silicon tetrachloride is burned with hydrogen and oxygen is generally known, but instead of silicon tetrachloride, silanes such as methyl trichlorosilane or trichlorosilane may be used alone or in combination with silicon tetrachloride. Examples of fumed silica include commercial products such as Aerosil® from Nippon Aerosil Co., Ltd. and REOLOSIL® from Tokuyama Corporation.

The particle properties of the fumed silica are as follows: the average primary particle size is preferably 40 nm or less, more preferably 15 nm or less. More preferably, the average primary particle size is 3 to 15 nm, and the specific surface area determined by the BET method is 200 m²/g or more (preferably, 250 to 500 m²/g).

The term "BET method" as used herein is one of methods of measuring the surface area of a powder based on a gas phase adsorption method, in which a total surface area of 1 g of a sample, i.e., a specific surface area, is determined from an adsorption isotherm. Generally, a nitrogen gas is often used as an adsorption gas, and a method of measuring the amount of adsorbed gas from the change in the pressure or volume of the adsorption gas is most often used. The Brunauer-Emmett-Teller equation called the BET equation is most known for representing an isotherm of multi-molecular adsorption, and is widely used for determination of the surface area of a powder. The amount of adsorbed gas is determined based on the BET equation, and the amount is multiplied by the area occupied by one adsorbed molecule on the adsorption surface to obtain the surface area.

As in the case of the wet-process silica, the fumed silica, if used, preferably has its particles dispersed to obtain an average secondary particle size of 500 nm or less. The average secondary particle size of the dispersed fumed silica is more preferably 10 to 300 nm, still more preferably 20 to 200 nm. A preferred dispersion method include pre-mixing a dispersion medium mainly containing fumed silica and water by general stirring with a propeller, stirring with a turbine, stirring with a homomixer, or the like, and dispersing the resulting product with a media mill (e.g., a ball mill, a bead mill, or a sand grinder), a pressure disperser (e.g., a high-pressure homogenizer or an ultrahigh-pressure homogenizer), an ultrasonic wave disperser, a thin-film spin disperser, or the like.

In the present invention, in view of easiness, the porous layer is preferably formed by applying a coating solution containing the fine particles described above to a support and drying the coating solution. For preparation of the coating solution, it is preferred to produce a slurry containing wet-process silica or fumed silica having an average secondary particle size of 500 nm or less, and the production of the slurry may employ various known methods to increase the concentration of the slurry or to improve the dispersion stability. Preferred examples include methods disclosed in JP 2002-144701 A and JP 2005-1117 A, in which silica particles are dispersed in the presence of an alkaline compound; a method in which silica particles are dispersed in the presence of a cationic compound; and a method in which silica particles are dispersed in the presence of a silane coupling agent. The method in which silica particles are dispersed in the presence of a cationic compound is more preferred.

Preferred examples of the cationic compound used in dispersion of the wet-process silica or fumed silica include polyethyleneimine, polydiallylamine, polymers having a structural unit derived from a diallylamine derivative, polyallylamine, alkylamine polymers, and polymers containing a primary, secondary, or tertiary amine group or a quaternary ammonium base. Polymers having a structural unit derived from a diallylamine derivative are particularly preferred. The molecular weight of each of these cationic polymers is preferably about 2000 to 100000, more preferably about 2000 to 30000, in terms of dispersibility and dispersion viscosity.

The alumina preferably contained in the porous layer in the present invention is preferably γ-alumina that is γ-crystalline aluminum oxide, particularly preferably δ group crystal. While there is a kind of γ-alumina whose primary particles have a particle size reduced to about 10 nm, common γ-alumina contains secondary particles and the particle size of crystalline secondary particles is several thousands to several ten thousands of nanometers. Thus, the γ-alumina that can be used is one in which crystalline secondary particles are ground with a device such as an ultrasonic wave disperser, a high-pressure homogenizer, or a counter collision jet pulverizer to obtain an average secondary particle size of preferably 500 nm or less, more preferably about 20 to 300 nm.

The alumina hydrate preferably contained in the porous layer in the present invention is represented by the composition formula: Al₂O₃·nH₂O (n = 1 to 3). Generally, the alumina hydrate can be obtained by a known production method such as hydrolysis of aluminum alkoxide such as aluminum isopropoxide, neutralization of an aluminum salt with an alkali, hydrolysis of an aluminate, or the like. The average secondary particle size of the alumina hydrate is preferably 500 nm or less, more preferably 20 to 300 nm.

The alumina and the alumina hydrate preferably contained in the porous layer in the present invention are preferably used in the form of dispersions obtained by dispersing the alumina and the alumina hydrate by a known dispersant such as acetic acid, lactic acid, formic acid, or nitric acid.

In the present invention, preferably, the porous layer contains the fine particles and a resin binder. Examples of the resin binder include polyvinyl alcohol, silanol-modified polyvinyl alcohol, oxidized starch, etherified starch, cellulose derivatives (e.g., carboxymethyl cellulose and hydroxyethyl cellulose), casein, gelatin, and soy protein. Examples also include conjugated diene copolymer latexes such as styrene-butadiene copolymers and methyl methacrylate-butadiene copolymers, and functional group-modified polymer latexes obtained by modifying these polymers with a functional group-containing monomer such as a carboxyl group. Examples also include water-based adhesives made of thermosetting synthetic resins such as melamine resin and urea resin, and adhesives made of synthetic resins such as polymethylmethacrylate, polyurethane resin, unsaturated polyester resin, vinyl chloride-vinyl acetate copolymers, polyvinyl butyral, and alkyd resin. These can be used alone or in combination. In addition, known natural or synthetic resin binders may be used alone or in combination without limitation.

Preferred among these are polyvinyl alcohols or silanol-modified polyvinyl alcohols, and particularly preferred are partially saponified polyvinyl alcohols having a degree of saponification of 80% or more, completely saponified polyvinyl alcohols, and silanol-modified polyvinyl alcohols. Preferably, the average degree of polymerization of the polyvinyl alcohol is 200 to 5000.

In the porous layer, the amount of the resin binder relative to the fine particles is not limited, but it is preferably 8 to 80 mass%, more preferably 8 to 50 mass%, relative to the fine particles, in order to form a porous layer.

The porous layer may also contain a hardener, if necessary, in addition to the resin binder. Specific examples of the hardener include aldehyde compounds such as formaldehyde and glutaraldehyde; ketone compounds such as diacetyl and chloropentanedione; bis(2-chloroethyl)urea; 2-hydroxy-4,6-dichloro-1,3,5-triazine; reactive halogen-containing compounds such as one disclosed in U.S. Patent No. 3,288,775; reactive olefin-containing compounds such as one disclosed in U.S. Patent No. 3,635,718; N-methylol compounds such as one disclosed in U.S. Patent No. 2,732,316; isocyanates such as one disclosed in U.S. Patent No. 3,103,437; aziridine compounds such as those disclosed in U.S. Patent No. 3,017,280 and U.S. Patent No. 2,983,611; carbodiimide compounds such as one disclosed in U.S. Patent No. 3,100,704; epoxy compounds such as one disclosed in U.S. Patent No. 3,091,537; dioxane derivatives such as dihydroxy dioxane; and inorganic cross-linking agents such as borax, boric acid, and borates. These can be used alone or in combination of two or more thereof. The amount of the hardener is not limited, but it is preferably 50 mass% or less, more preferably 40 mass% or less, particularly preferably 30 mass% or less, relative to the resin binder.

When the resin binder is a partially saponified polyvinyl alcohol having a degree of saponification of 80% or more, a completely saponified polyvinyl alcohol, or a silanol-modified polyvinyl alcohol, the hardener is preferably borax, boric acid, or a borate, particularly preferably boric acid. The amount of boric acid used is preferably 40 mass% or less, more preferably 30 mass% or less, particularly preferably 20 mass% or less, relative to the polyvinyl alcohol. A preferred lower limit is 0.1 mass% or more.

In addition, the porous layer can contain additives such as preservatives, surfactants, coloring dyes, UV absorbers, antioxidants, dispersants for fine particles, antifoamers, leveling agents, viscosity stabilizers, and pH adjusters, if necessary.

Preferably, the porous layer further contains at least one compound selected from glycerol or polyglycerol. This can suppress a phenomenon in which the porous layer formed on the support of the transfer sheet is partially peeled off from the support and transferred with a dissociation layer to a transfer-receiving body during transfer of the transfer pattern to cause contamination on a pattern-transferred surface of a pattern-transferred product.

Polyglycerol is a compound having a structure in which multiple glycerol units are polymerized. Examples include commercial products such as Diglycerin S (polyglycerol (diglycerol) having a degree of polymerization of 2), Polyglycerin #310 (polyglycerol having a degree of polymerization of 4), Polyglycerin #500 (polyglycerol having a degree of polymerization of 6), and Polyglycerin #750 (polyglycerol having a degree of polymerization of 10) from Sakamoto Yakuhin Kogyo Co., Ltd. Examples also include commercial products such as Polyglycerin 03P (PGL 03P) (polyglycerol (triglycerol) having a degree of polymerization of 3), Polyglycerin 06 (PGL 06) (polyglycerol having a degree of polymerization of 6), Polyglycerin 10PSW (PGL 10PSW) (polyglycerol having a degree of polymerization of 10), Polyglycerin 20PW (PGL 20PW) (polyglycerol having a degree of polymerization of 20), and Polyglycerin XPW (PGL XPW) (polyglycerol having a degree of polymerization of 40) from Daicel Corporation. These products can be purchased and used.

The amount of the at least one compound selected from glycerol or polyglycerol is preferably 2.5 mass% or more, more preferably 7.5 mass% or more, particularly preferably 12.5 mass% or more, relative to the coating amount based on the solid content of the porous layer. The upper limit is not limited, but it is preferably 30 mass% or less in order not to impair the absorbability of the porous layer for the solvent components contained in an ink or paste used to form a transfer pattern.

Examples of the method of allowing the porous layer to contain the at least one compound selected from glycerol or polyglycerol include one in which these compounds are added to a coating solution for forming the porous layer, and the mixture is applied and dried; one in which an aqueous solution containing these compounds is applied to the porous layer and dried; and one in which these compounds are added to a coating solution for forming the dissociation layer, which is applied to the porous layer, and the mixture is applied and dried.

The thickness of the porous layer (when dry) is preferably 1 to 100 µm, more preferably 5 to 50 µm. The porous layer may include two or more porous layers. In this case, the structures of these porous layers may be the same as or different from each other. For example, a porous layer containing alumina hydrate may be formed on a porous layer containing wet-process silica.

The porous layer can be formed as follows: components such as fine particles and a resin binder are dissolved or dispersed in a suitable solvent to prepare a coating solution; and the coating solution is applied to the entire surface of the support or is selectively applied to a portion of the support where coating is required, using any of various known coating or printing methods. Examples of the coating methods include slide curtain coating, slide bead coating, slot die coating, direct gravure roll coating, reverse gravure roll coating, spray coating, air knife coating, blade coating, rod bar coating, and spin coating; and example of the printing methods include screen printing, inkjet printing, dispenser printing, offset printing, reverse offset printing, gravure printing, and flexographic printing. After coating, the surface of the porous layer can be made smooth by casting to press the porous layer against a mirror surface roll or by calendaring.

In the present invention, the transfer sheet includes a dissociation layer on the porous layer. The dissociation layer is a layer that separates between the porous layer and a transfer pattern during transfer of the transfer pattern to a transfer-receiving body. As shown in Fig. 3, only the transfer pattern can be transferred to the transfer-receiving body, or as shown in Fig. 4 and Fig. 6, the transfer pattern can be transferred with a portion of the dissociation layer to the transfer-receiving body. The transferred portion of the dissociation layer may be removed by washing or wiping, if necessary.

Preferably, the dissociation layer in the present invention mainly contains fine particles selected from inorganic fine particles or organic fine particles, and preferably, the dissociation layer is a layer that does not melt or is not adhesive at a temperature during pattern transfer. The expression "mainly contains" means that 93 mass% or more, preferably 98 mass% or more, of the total solid content of the dissociation layer are fine particles selected from inorganic fine particles or organic fine particles.

The inorganic fine particles contained in the dissociation layer in the present invention can be selected from various known inorganic fine particles. Examples of the inorganic fine particles include inorganic fine particles of magnesium carbonate, calcium sulfate, barium sulfate, titanium dioxide, zinc oxide, zinc sulfide, zinc carbonate, aluminum silicate, calcium silicate, magnesium silicate, amorphous synthetic silica, alumina, alumina hydrate, magnesium hydroxide, cerium oxide, zirconium oxide, niobium oxide, tin oxide, and the like. These may be used in combination of two or more thereof.

The average primary particle size of the inorganic fine particles contained in the dissociation layer is preferably 10 to 200 nm, more preferably 20 nm or more. An average primary particle size of less than 10 nm may cause blocking of pores of the porous layer, reducing the absorbability. An average primary particle size of more than 200 nm may cause sedimentation of inorganic particles in a coating solution used to form the dissociation layer, making it difficult to apply the coating solution.

Such inorganic fine particles are preferably used in the form of a dispersion of colloidal inorganic fine particles. Examples include colloidal silica, titanium oxide sol, alumina sol, cerium oxide sol, zirconium oxide sol, niobium oxide sol, and tin oxide sol. Examples of the zirconium oxide sol include commercial products such as ZSL-20N from Daiichi Kigenso Kagaku Kogyo Co., Ltd. and 0Zr100/20 from Nyacol Nano Technologies, Inc. (USA). Examples of the cerium oxide sol include commercial products such as CEO2 (AC) from Nyacol Nano Technologies, Inc. (USA). Examples of the niobium oxide sol include commercial products such as BIRAL® from Taki Chemical Co., Ltd.

Examples of colloidal silica include unmodified colloidal silica obtained by growing particles from silica sol under slightly alkaline conditions; colloidal silica with the amount of alkali components reduced by ion exchange; anion-enhanced colloidal silica obtained by replacing some silicon atoms in silica with aluminum atoms; cationic colloidal silica obtained by surface treatment using alumina; and synthetic colloidal silica obtained by the sol-gel method using alkoxysilane as a raw material. Any of these types can be used. Examples of these types of colloidal silica include commercial products such as SNOWTEX® from Nissan Chemical Corporation and Quartron® from Fuso Chemical Co., Ltd.

The organic fine particles contained in the dissociation layer in the present invention can be selected from various known organic fine particles. Examples include organic fine particles of acrylic resin, styrene resin, polyamide, silicone resin, fluororesin, phenolic resin, polyvinyl acetal, polyimide, epoxy resin, polyphenylene sulfide, polyether sulfone, polyamide imide, and the like. These may be used in combination of two or more thereof.

The average primary particle size of the organic fine particles contained in the dissociation layer is preferably 10 to 500 nm, more preferably 20 nm or more. An average primary particle size of less than 10 nm may cause blocking of pores of the porous layer, reducing the absorbability. An average primary particle size of more than 500 nm may cause sedimentation of organic particles in a coating solution used to form the dissociation layer, making it difficult to apply the coating solution.

Examples of such organic fine particles include commercial products such as Toraypearl® PAI from Toray Industries, Inc. for polyamide imide; Toraypearl PES from Toray Industries, Inc. for polyether sulfone; and 31-JR from Chemours-Mitsui Fluoroproducts Co., Ltd. and D-210C from Daikin Industries, Ltd. for fluororesin.

The dissociation layer in the present invention can also contain a combination of one or more inorganic fine particles and one or more organic fine particles described above. Preferably, the volume ratio of the inorganic fine particles to the organic fine particles when used in combination is in the range of 1: 9 to 9: 1. Preferably, the dissociation layer contains inorganic fine particles to provide excellent conductivity when the resulting pattern-transferred product is a conductive pattern-transferred product, and to provide excellent reflectance when the resulting pattern-transferred product is a metallic pattern-transferred product.

Components other than the inorganic fine particles and/or organic fine particles contained in the dissociation layer in the present invention include a water-soluble resin such as polyvinyl alcohol or a latex as a resin binder, a resin binder hardener, a surfactant, and the like.

In the present invention, the coating amount based on the solid content of the dissociation layer is preferably 0.01 g/m² or more, more preferably 0.1 g/m² or more. A coating amount based on the solid content of less than 0.01 g/m² may cause transfer of the porous layer to a transfer-receiving body. The upper limit of the coating amount based on the solid content of the dissociation layer is not limited, but it is preferably 10 g/m² or less because an amount of more than 10 g/m² is highly likely to cause cracking in the dissociation layer mainly containing inorganic fine particles and/or organic fine particles.

The dissociation layer can be formed as follows: the coating solution to form the dissociation layer is applied to the entire surface of the porous layer surface formed in advance on the support or is selectively applied to a portion of the porous layer surface where coating is required, using any of various known coating or printing methods. Examples of the coating methods include slide curtain coating, slide bead coating, slot die coating, direct gravure roll coating, reverse gravure roll coating, spray coating, air knife coating, blade coating, rod bar coating, spin coating, and inkjet coating; and examples of the printing methods include screen printing, inkjet printing, dispenser printing, offset printing, reverse offset printing, gravure printing, and flexographic printing. Preferably, the coating method is reverse gravure roll coating. More preferably, the reverse gravure roll coating is a method using a tri-helical gravure roll (gravure roll including oblique grooves) having a roll diameter of 100 mm or less (more preferably 20 to 80 mm).

In the transfer sheet of the present invention, when a solvent or dispersion used in the coating solution to form the porous layer and a solvent or dispersion used in the coating solution to form the dissociation layer are both mainly water, a coating method capable of coating multiple layers simultaneously, such as multilayer slide curtain coating, multilayer slide bead coating, or multilayer slot die coating, may be used to simultaneously form the porous layer and the dissociation layer. Alternatively, a tandem multilayer coater may be used in which multiple coaters are placed on a line for conveying the support.

A transfer pattern formed on the dissociation layer of the transfer sheet in the present invention can be suitably selected according to the purpose of use of the resulting pattern-transferred product. Preferably, the transfer pattern is a conductive pattern, a metallic pattern, or a pattern printed with pigment inks because a pattern-transferred product having good adhesion between the transferred pattern and a transfer-receiving body can be obtained. In view of easiness, the transfer pattern is preferably formed on the dissociation layer of the transfer sheet, using an ink or paste mainly containing conductive fine particles or a fine particle component of a pigment to form a pattern. An ink or paste used to form a transfer pattern that can be suitably used in the present invention are those whose fine particle components are large enough to be retained on the dissociation layer, i.e., those whose fine particle components are larger than gaps formed in the dissociation layer. The average particle size of the fine particle components is preferably 1 nm to 10 µm, more preferably 1 nm to 1 µm. The average particle size of the fine particle components in the present invention is an average particle size determined by electron microscopic observation of the fine particles, with the particle size being the diameter of a circle equivalent to a projected area of each of 100 particles present in a certain area.

In the present invention, examples of the ink or paste used when the transfer pattern is a conductive pattern or a metallic pattern include inks or pastes containing fine metal particles which are conductive fine particles. The ink or paste containing fine metal particles used in the present invention can be selected from various known inks or pastes. Examples include silver nano ink, copper nano ink, silver paste, copper paste, and aluminum paste. An ink or paste containing other conductive fine particles, such as a carbon ink or carbon paste, can also be used to form a conductive pattern. Preferred among these are silver nano ink containing ultrafine silver particles and silver paste containing fine silver particles because the resulting conductive pattern transferred to a transfer-receiving body has excellent conductivity and is resistant to oxidation. Silver nano ink is more preferred because it can form a very thin (about 1 µm) conductive pattern. Examples of the silver nano ink include commercial products such as NBSIJ series from Mitsubishi Paper Mills Limited, and examples of the silver paste include commercial products such as DOTITE® series from Fujikura Kasei Co., Ltd.

In the present invention, a pattern is formed on the dissociation layer of the transfer sheet with the ink or paste containing conductive fine particles by various printing methods or coating methods. A pattern can be formed by, for example, various printing methods such as dispenser printing capable of linearly coating an object; various types of inkjet printing such as thermal inkjet printing, piezo inkjet printing, micropump inkjet printing, and static inkjet printing; and various known printing methods such as letterpress printing, flexographic printing, planographic printing, intaglio printing, gravure printing, reverse offset printing, sheet-fed screen printing, and rotary screen printing. Alternatively, a continuous plane pattern can be formed on the entire or partial surface of the dissociation layer of the transfer sheet by various known coating methods such as gravure roll coating, slot die coating, and spin coating; a discontinuous plane pattern can be formed on the entire or partial surface of the dissociation layer of the transfer sheet, using an intermittent coating die coater or the like; or a pattern can be formed by attaching the ink or paste to the entire dissociation layer of the transfer sheet by immersion coating (also referred to as "dipping"). Examples of more preferred printing methods include inkjet printing, flexographic printing, gravure printing, reverse offset printing, sheet-fed screen printing, and rotary screen printing.

The ink or paste containing conductive fine particles applied to form of a pattern on the dissociation layer of the transfer sheet by any of the above methods may be thermally cured or fired to provide a transfer pattern after a dispersion medium contained in the ink or paste is volatilized and/or absorbed by the porous layer. Further, it is preferred to obtain a transfer pattern using an ink containing ultrafine metal particles mainly made of silver by adding a conductivity developer disclosed in JP 2008-4375 A, JP 2008-235224 A, or the like to the porous layer and/or the dissociation layer and forming bonds between the ultrafine metal particles by chemical action. A porous transfer pattern is obtained when ultrafine metal particles are bonded by chemical action. Thus, a component such as an adhesive resin on a surface of a transfer-receiving body enters the transfer pattern, achieving a high adhesive force between the transfer pattern and the transfer-receiving body. Examples of the conductivity developer include sodium chloride, potassium chloride, calcium chloride, and ammonium chloride.

In the present invention, examples of the ink or paste containing a pigment used when the transfer pattern is a pattern printed with pigment inks include inkjet printing pigment inks such as water-based pigment ink, non-water-based pigment ink, and UV curable pigment ink; electrophotographic printing inks; and printing inks for screen printing and the like. Water-based pigment ink for inkjet printing is particularly preferred because it results in a pattern having excellent resolution owing to the pigment transferred to a transfer-receiving body. The ink or paste containing a pigment is applied by various printing or coating methods to form a pattern on the dissociation layer of the transfer sheet, as is the case with the ink or paste containing conductive fine particles.

The water-based pigment ink for inkjet printing preferably used in the present invention can be a known one containing the followings: at least one of a pigment, a pigment dispersant, an emulsion thermoplastic resin, or a water-soluble thermoplastic resin; a water-soluble organic solvent whose boiling point at 1 atm is 250°C or lower; a surfactant; water; and the like. Each component may be used alone or in combination of two or more thereof. Preferred amount of each component relative to the total mass (100 mass%) of the ink is as follows: pigment: 0.2 to 10 mass%; the total of pigment dispersant, emulsion thermoplastic resin, and water-soluble thermoplastic resin: 1.5 to 15 mass%; water-soluble organic solvent whose boiling point at 1 atm is 250°C or lower: 5 to 40 mass%; surfactant: 0.5 to 2 mass%; and water: 50 to 92 mass%.

In the present invention, the thickness of the transfer pattern formed on the dissociation layer of the transfer sheet is not limited, but it is preferably 0.1 to 20 µm, more preferably 0.2 to 10 µm.

In the present invention, a pattern-transferred product is obtained by the step of transferring the transfer pattern formed on a transfer sheet to a transfer-receiving body having an adhesive surface and the step of removing adhesion from the surface of the transfer-receiving body. Alternatively, a pattern-transferred product is obtained by the step of transferring the transfer pattern formed on a transfer sheet to a transfer-receiving body via an adhesive material and the step of removing adhesion from the adhesive material. The term "adhesive" as used herein means that the adhesive force (N/25 mm) per 25 mm width is 0.1 N/25 mm or more as measured at a peeling angle of 180 degrees according to JIS Z 0237.

In the present invention, the adhesive force of the transfer-receiving body having an adhesive surface and the adhesive material is preferably 0.1 to 20 N/25 mm, more preferably 0.2 to 10 N/25 mm. An adhesive force of less than 0.1 N/25 mm may result in failed transfer of a transfer pattern due to insufficient adhesion. An adhesive force of more than 20 N/25 mm may result in difficulty in peeling off the transfer sheet from the transfer-receiving body.

In one embodiment of the present invention, the transfer-receiving body having an adhesive surface may be a transfer-receiving body that is adhesive at room temperature and whose adhesion is removed by thermal curing (hereinafter referred to as a "transfer-receiving body A"). The transfer-receiving body A contains a resin that is soft and adhesive at room temperature and that is thermally cured. Known examples of such a resin include thermosetting resins, such as liquid resol-type phenolic resin, novolac phenolic resin, furan resin, epoxy resin, unsaturated polyester resin, urea resin, melamine resin, and alkyd resin. When producing a transfer-receiving body using these resins, the following additives may be used in addition to the thermosetting resins: curing agents such as acid curing agents and amine curing agents; plasticizers such as phthalic ester plasticizers, phosphate ester plasticizers, fatty acid ester plasticizers, and epoxy plasticizers; pigments such as powdered titanium oxide and carbon black; fillers such as aluminum hydroxide, zinc oxide, and calcium carbonate; and reinforcing materials such as glass fiber, carbon fiber, and aramid fiber. The term "room temperature" as used herein refers to the temperature range specified in JIS Z 8703, specifically 5°C to 35°C.

In particular, there are materials widely used as carbon fiber reinforced resin prepreg and glass fiber reinforced resin prepreg, which are obtained by allowing carbon fiber or glass fiber to be impregnated with a thermosetting resin (e.g., epoxy resin, phenolic resin, or unsaturated polyester resin) containing a curing agent and the like; molding the resin into a film; attaching a release film or release paper to each side of the film; and bringing the resulting film into a semi-cured state by heating or drying. These materials are adhesive at room temperature so that they are easily adhered and integrated with each other when overlaid together in a semi-cured state. Thus, such a prepreg material can be suitably used as the transfer-receiving body A in the present invention. Epoxy resin sheets made of an epoxy resin containing a curing agent and the like in the form of sheets are commercially available to produce prepreg. Such a sheet can also be suitably used as the transfer-receiving body A in the present invention.

The transfer-receiving body A containing a thermosetting resin in the present invention may be a solder resist layer used for an outer layer surface of a conductive material or the like. The solder resist layer may be a layer that can be made of either a one-component or two-component liquid solder resist. A resist in the form of a dry film can also be used. The solder resist layer contains, for example, an alkali-soluble resin, a polyfunctional acrylic monomer, a photo-initiator, an epoxy resin, an inorganic filler, and the like.

Examples of the alkali-soluble resin include alkali-soluble resins having photocurable and thermosetting properties, such as a resin obtained by adding an acid anhydride to a secondary hydroxyl group of an epoxy acrylate resin obtained by adding acrylic acid to a novolac epoxy resin. Examples of the polyfunctional acrylic monomer include trimethylolpropane triacrylate, dipentaerythritol hexaacrylate, and pentaerythritol triacrylate. Examples of the photo-initiator include 2-methyl-1-(4-methylthiophenyl)-2-morpholinopropan-1-one. The epoxy resin is used as a curing agent and is reacted with a carboxylic acid of an alkali-soluble resin to form a crosslink in order to improve properties such as heat resistance and chemical resistance. A reaction of a carboxylic acid with an epoxy proceeds at room temperature, which results in poor storage stability. Thus, many alkali development-type solder resists are of a two-component type used by mixing at the time of use. Examples of the inorganic filler include barium sulfate and silica.

Examples of commercial products of the liquid solder resist that can be used in the present invention include PLAS FINE® PSR-310 (A-99F), PLAS FINE PSR-310 (SC-84), and PLAS FINE PSR-310 (SW-26) from Goo Chemical Co., Ltd.; USR-2B14-84-200, USR-2G14-94-250, and DSR-330S32-21 from Tamura Corporation; and PFR-800 AUS410, PSR-4000 G24K, PSR-4000 LEW3, and S-40 T1 from Taiyo Ink Mfg. Co., Ltd. Examples of the solder resist in the form of a dry film include PFR-800 US 410 from Taiyo Ink Mfg. Co., Ltd. and NIT215 from Nikko-Materials Co., Ltd.

The surface of the transfer-receiving body A is adhesive at room temperature, and a transfer pattern is transferred while adhesion is exhibited. Transfer is performed by attaching a transfer pattern-formed surface of a transfer sheet to the transfer-receiving body A and peeling them off from each other. For example, when the transfer-receiving body A is a three-dimensional object, transfer is performed by attaching a transfer sheet to the transfer-receiving body A and peeling off the transfer sheet. For example, when the transfer-receiving body A is prepreg or a sheet such as a solder resist layer, preferably, the transfer sheet is pressure-bonded to the transfer-receiving body A by lamination using a roll laminator. Laminating conditions are preferably a roll temperature of 5°C to 35°C (room temperature), a pressure of 1 to 50 N/cm², and a duration of 0.1 seconds to 5 minutes, more preferably a pressure of 5 to 20 N/cm² and a duration of 1 second to 1 minute. These conditions can be suitably adjusted according to the thickness and type of the transfer-receiving body A, for example. A pressure of less than 1 N/cm² may result in non-uniform transfer of a transfer pattern to the transfer-receiving body A. A pressure of more than 50 N/cm² may result in difficulty in peeling off the transfer sheet.

When peeling the transfer sheet and the transfer-receiving body A from each other, the transfer-receiving body A is preferably peeled off at a smaller peeling angle that is set according to JIS Z 0237. Peeling off the transfer-receiving body A from the transfer sheet may cause bending of the transfer-receiving body A at a peeling portion, depending on the peeling method. When the transfer pattern is a conductive pattern, the conductive pattern is also bent due to the bending of the transfer-receiving body A during peeling. A smaller bending angle is preferred because a decrease in conductivity of conductive pattern is smaller. Specifically, the transfer-receiving body A is preferably peeled off at a peeling angle of 90 degrees or less. More preferably, peeling is performed by bending the transfer sheet but not bending the transfer-receiving body A at a peeling angle of the transfer-receiving body A set to 0 degrees. Although it depends on the thickness of the conductive pattern, a peeling angle of the transfer-receiving body A of more than 90 degrees may reduce the conductivity of the conductive pattern by about several tens of percent.

The transfer-receiving body A containing a thermosetting resin in the present invention is subjected to thermal curing after transfer of a transfer pattern to remove adhesion from the surface of the transfer-receiving body A. Thermal curing increases the adhesive force of the transfer pattern to the transfer-receiving body A. When the transfer-receiving body A is prepreg, the prepreg with a transfer pattern transferred thereto may be directly thermally cured to provide a pattern-transferred product; or, if necessary, another prepreg without a transfer pattern transferred thereto may be superimposed on a transfer pattern and molded, and the molded product may be thermally cured to provide a pattern-transferred product. Heating is performed under conditions of temperature and time that are suitable for thermosetting resins. For example, in the case of an epoxy resin, the temperature is preferably 130°C to 200°C, more preferably 140°C to 190°C, and the heating time is about 5 minutes to 2 hours, but these conditions are not limited.

In one embodiment of the present invention, the transfer-receiving body having an adhesive surface may be a transfer-receiving body that is not adhesive at room temperature, that becomes adhesive when heated, and whose adhesion is removed by thermal curing (hereinafter referred to as a "transfer-receiving body B"). The transfer-receiving body B is made of one of a thermosetting resin or a resin mixture containing a thermosetting resin and a thermoplastic resin. Specifically, the transfer-receiving body B is preferably one that is not adhesive at room temperature, that becomes adhesive at a temperature of about 40°C or higher, and that is cured at a temperature of 130°C or higher. Specifically, the transfer-receiving body B can be obtained by adding additives such as an curing agent, an inorganic filler, and various coupling agents to a resin such as an epoxy resin, a maleimide compound, a benzoxazine compound, or a cyanate resin, or to a mixture containing two or more of these resins, and molding a mixture of the resin(s) and additives. Examples of commercial products used as the transfer-receiving body B include ABF-T31 from Ajinomoto Co., Inc., Zaristo®-125 from Taiyo Ink Mfg. Co., Ltd., LAZ®-7752 from Sumitomo Bakelite Co., Ltd., and NX04H from Sekisui Chemical Co., Ltd.

Heating conditions to make the surface of the transfer-receiving body B adhesive are not limited but preferably 40°C to 160°C for 10 to 90 minutes, more preferably 60°C to 130°C for 10 to 90 minutes. Heating at a high temperature over 160°C may cause thermal curing, failing to provide adhesion required for transfer of a transfer pattern, and resulting in poor adhesion between the transfer-receiving body and the transfer pattern. In order to improve the efficiency of the heating step and the subsequent transferring step, the transfer-receiving body can include a support thermally pressure-bonded to a back side of a transfer-receiving surface.

The transfer-receiving body B is not adhesive at room temperature and becomes adhesive at a temperature of 40°C or higher. A transfer pattern is transferred while adhesion is exhibited. Transfer is performed by attaching a transfer pattern-formed surface of a transfer sheet to the transfer-receiving body B and peeling them off from each other. For example, when the transfer-receiving body B is a three-dimensional object, transfer is performed by attaching a transfer sheet to the transfer-receiving body B and peeling off the transfer sheet. For example, when the transfer-receiving body B is a sheet, preferably, the transfer sheet is pressure-bonded to the transfer-receiving body B by lamination using a roll laminator. Preferred laminating conditions are as described above for the transfer-receiving body A, except that the roll temperature is 40°C or higher. A preferred peeling angle to peel the transfer sheet and the transfer-receiving body B from each other is as described above for the transfer-receiving body A. Preferred conditions for thermal curing after transfer of a transfer pattern to the transfer-receiving body B are as described above for the transfer-receiving body A.

In one embodiment of the present invention, the transfer-receiving body having an adhesive surface may be a transfer-receiving body that is not adhesive at room temperature, that becomes adhesive when heated, and whose adhesion is removed by natural cooling (hereinafter referred to as a "transfer-receiving body C"). Such a transfer-receiving body C contains a resin that is not adhesive at room temperature, that becomes adhesive when heated, and that loses its adhesion when naturally cooled to room temperature. A thermoplastic resin is known as such a resin. Non-limiting examples include polyolefin resins (e.g., polyethylene, polypropylene, and cyclic polyolefin), vinyl chloride resins (e.g., polyvinyl chloride and vinyl chloride copolymers), polystyrene, polyvinyl acetate, acrylic resins (e.g., polymethylmethacrylate), polyurethane, ABS resin, ASA resin, AS resin, polyamide, polyacetal, polycarbonate, polyethylene terephthalate, polybutylene terephthalate, polylactic acid, polyphenylene sulfide, polysulfone, polyether sulfone, thermoplastic polyimide, polyamide imide, and polyether imide.

The transfer-receiving body C can be a molded product obtained by molding the thermoplastic resin by a known processing method such as injection molding, extrusion, and 3D printing into a three-dimensional object having a complicated shape, a sheet, a film, or the like.

The heating temperature to make the transfer-receiving body C adhesive is different depending on the thermoplastic resin, and is preferably equal to or higher than the glass-transition temperature. For example, preferably, vinyl chloride resin is heated at 90°C or higher; polystyrene and acrylic resin are heated at 100°C or higher; AS resin and ABS resin are heated at 110°C or higher; and polycarbonate is heated at 150°C or higher.

The transfer-receiving body C is not adhesive at room temperature. Thus, the transfer-receiving body C is heated to soften its thermoplastic resin so that the surface becomes adhesive. Then, a transfer pattern is transferred while adhesion is exhibited. Transfer is performed by attaching a transfer pattern-formed surface of a transfer sheet to the transfer-receiving body C and peeling them off from each other. The transfer sheet can be peeled off while the transfer-receiving body C is softened by heating and adhesive or while the transfer-receiving body C is naturally cooled and is no longer adhesive. Yet, preferably, the transfer sheet is peeled off while the transfer-receiving body C is naturally cooled and is no longer adhesive. Ultimately, the transfer-receiving body C is cooled to room temperature. When the transfer-receiving body C is a three-dimensional object having a complicated shape, transfer may be performed by attaching a transfer sheet to the transfer-receiving body C by entirely heating the transfer-receiving body C or partially heating a transfer-receiving portion of the transfer-receiving body C and peeling off the transfer sheet. For example, transfer may be performed by attaching a transfer sheet to a transfer-receiving portion of the transfer-receiving body C, pressing a heating element having a size large enough to cover the entire transfer pattern against a back side of the transfer sheet, and heating the transfer-receiving body C through the transfer sheet to make the transfer-receiving body C adhesive.

When the transfer-receiving body C is a film or a sheet such as a thin plate, preferably, a transfer pattern is thermally pressure-bonded by a laminating method using a roll laminator. Laminating conditions are preferably a roll temperature of a degree at which the transfer-receiving body C becomes adhesive, a pressure of 1 to 500 N/cm², and a duration of 0.1 seconds to 5 minutes, more preferably a pressure of 10 to 300 N/cm² and a duration of 1 second to 1 minute. These conditions can be suitably adjusted according to the thickness and type of the transfer-receiving body C, for example. A pressure of less than 1 N/cm² may result in non-uniform transfer of a transfer pattern to the transfer-receiving body C. A pressure of more than 500 N/cm² may result in difficulty in peeling off the transfer sheet.

In the present invention, after the transfer pattern is transferred and the transfer sheet is peeled off, the transfer-receiving body C may be re-heated. Re-heating further improves the adhesion between the transfer-receiving body C and the transfer pattern. Reheating conditions are not limited but preferably 100°C to 200°C for 1 to 60 minutes, more preferably 120°C to 160°C for 1 to 60 minutes.

In one embodiment of the present invention, a pattern-transferred product is obtained by the step of transferring the transfer pattern formed on a transfer sheet to a transfer-receiving body via an adhesive material and the step of removing adhesion from the adhesive material. In this embodiment, transfer may be performed by the following method: a transfer pattern-formed surface of a transfer sheet is attached to a transfer-receiving body via a material that is not adhesive at room temperature and that becomes adhesive when heated (hereinafter referred to as a "heat-sensitive adhesive material") to transfer a transfer pattern, and subsequently, the transfer-receiving body is naturally cooled to room temperature so as to naturally cool the heat-sensitive adhesive material between the transfer sheet and the transfer-receiving body to remove adhesion.

In the present invention, a transfer-receiving body to which a transfer pattern is transferred via a heat-sensitive adhesive material (hereinafter referred to as a "transfer-receiving body D") does not become adhesive by itself. A transfer pattern-formed transfer sheet is thermally pressure-bonded to the transfer-receiving body D via a heat-sensitive adhesive material to transfer the transfer pattern. Non-limiting examples the transfer-receiving body D include general paper, fiber materials, synthetic leather, resin molded products, metal molded products, glass mold products, ceramics, and wood processed products. For example, the fiber material may be any of a natural fiber material, a semi-synthetic fiber material, or a synthetic fiber material. Examples of the natural fiber material and the semi-synthetic fiber material include cellulose fiber materials such as cotton, linen, lyocell, rayon, and acetate; and protein fiber materials such as silk, wool, and animal hair. Examples of the synthetic fiber material include polyamide fiber (nylon), vinylon fiber, polyester fiber, and acrylic fiber. The fiber material may have a woven, knitted, or non-woven structure. The fiber material may be cross woven fabric or cross knitted fabric, or may use a blended yarn, a multifilament yarn. Various shapes from a flat sheet to a three-dimensional shape can be suitably used regardless of the thickness and mass. Yet, the surface to which a transfer pattern is to be transferred is preferably a flat or continuous surface to ensure excellent adhesion for the transfer pattern.

The heat-sensitive adhesive material in the present invention may be a known material such as a thermoplastic resin latex, thermoplastic resin fine particles, or a thermoplastic resin film sheet. The thermoplastic resin latex may be a product obtained by dispersing a thermoplastic resin in water by a surfactant. Examples of the thermoplastic resin include homopolymers and copolymers made from acrylic acid, methacrylic acid, acrylates, methacrylates, styrene, substituted styrenes, vinyl halides, fluorinated monomers such as tetrafluoroethylene, vinylidene halides, vinyl esters, vinyl ethers, and fluorovinyl ethers. Examples of the thermoplastic resin also include homopolymers such as polyamide, polyester, polyurethane, epoxy resin, and silicone resin, and copolymers. Examples of the thermoplastic resin fine particles include fine particles of these thermoplastic resins. Suitable examples of the thermoplastic resin film sheet include film sheets made of these thermoplastic resins. Of these, thermoplastic resin film sheets are preferably used because they provide excellent adhesion between the transfer-receiving body D and a transfer pattern and they are easy to use. Examples of the thermoplastic resin film sheet include commercial products such as ELPHAN® series from Nihon Matai Co., Ltd., KuranBeter® series from Kurabo Industries Ltd., Ecellent® series from Sheedom Co., Ltd., and polyester hot melt adhesive sheets from Nitto Shinko Corporation.

The amount or thickness of the heat-sensitive adhesive material in the present invention is not limited, but the amount based on the solid content of thermoplastic resin latex or thermoplastic resin fine particles is preferably 2 to 200 g/m², more preferably 5 to 100 g/m². The thickness of the thermoplastic resin film sheet is preferably 2 to 200 µm, more preferably 5 to 100 µm.

Examples of the method of transferring a transfer pattern to the transfer-receiving body D via a heat-sensitive adhesive material in the present invention include the followings: one in which a thermoplastic resin latex is applied to and dried on at least one of a transfer pattern-formed surface of a transfer pattern-formed transfer sheet or a transfer-receiving surface of the transfer-receiving body D, followed by thermal transfer of the transfer pattern; one in which thermoplastic fine particles are placed between a transfer pattern-formed surface of a transfer pattern-formed transfer sheet and a transfer-receiving surface of the transfer-receiving body D, followed by thermal transfer of the transfer pattern; one in which a thermoplastic resin film sheet is placed between a transfer pattern-formed surface of a transfer pattern-formed transfer sheet and a transfer-receiving surface of the transfer-receiving body D, followed by thermal transfer of the transfer pattern; and one in which a transfer pattern is formed in advance on a transfer sheet using an ink or paste containing a thermoplastic resin, and the transfer pattern is directly thermally transferred to the transfer-receiving body D.

The heat-sensitive adhesive material in the present invention has a surface that becomes adhesive when heated during transfer. The heat-sensitive adhesive material can be heated during transfer by a known heating method such as hot pressing, hot roll pressing, high frequency heating, or ultrasonic heating. Of these, hot roll pressing is preferred. Heating conditions by hot roll pressing are preferably a roll temperature of 80°C to 200°C, a pressure of 1 to 50 N/cm², and a duration of 1 second to 5 minutes, more preferably a roll temperature of 100°C to 160°C, a pressure of 5 to 20 N/cm², and a duration of 10 seconds to 1 minute, but the heating conditions are not limited thereto and can be suitably adjusted according to the thickness and amount of the heat-sensitive adhesive material. A roll temperature of more than 200°C, a pressure of more than 50 N/cm², and/or a heating time of more than 5 minutes may result in difficulty in peeling off the transfer sheet.

After the heat-sensitive adhesive material is heated by hot roll pressing or the like to transfer a transfer pattern, preferably, the heat-sensitive adhesive material is naturally cooled to 50°C or lower before peeling off the transfer sheet. More preferably, the heat-sensitive adhesive material is naturally cooled to 40°C or lower for peeling. The transfer sheet may be peeled off from the transfer-receiving body D at any peeling rate, but preferably, the transfer sheet is peeled off at a peeling rate of 1000 mm/min or less in a 180-degree direction in order to successfully transfer a transfer pattern.

In the present invention, after the transfer pattern is transferred and the transfer sheet is peeled off, the heat-sensitive adhesive material may be re-heated. Re-heating further improves the adhesion between the transfer-receiving body D and the transfer pattern. Reheating conditions are as described for the transfer-receiving body C.

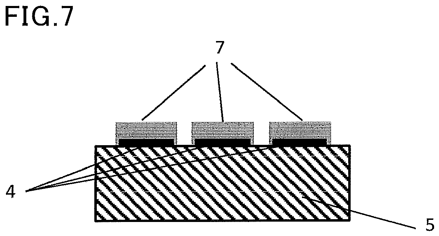

In the present invention, when the transfer-receiving body is the transfer-receiving body A or the transfer-receiving body B and the transfer pattern is a conductive pattern, preferably, the attached transfer sheet is peeled off after the step of transferring the transfer pattern; a plating layer is then formed by plating on a surface of the conductive pattern transferred to the transfer-receiving body; and ultimately, the transfer-receiving body having the plated conductive pattern is thermally cured. This makes it possible to produce a pattern-transferred product (Fig. 7) having excellent conductivity and good adhesion between the transfer-receiving body and the conductive pattern with simple steps. When the transfer-receiving body is a transfer-receiving body C and the transfer pattern is a conductive pattern, preferably, a plating layer is formed by plating on a surface of the conductive pattern transferred to the transfer-receiving body after the step of removing adhesion from the surface of the transfer-receiving body. This makes it possible to produce a pattern-transferred product (Fig. 7) having excellent conductivity and good adhesion between the transfer-receiving body and the conductive pattern with simple steps.

Plating in the present invention may be either electroless plating or electroplating.

Electroless plating techniques are described in "Electroless Plating" edited by Electroplater's Technical Association and published by The Nikkan Kogyo Shimbun, Ltd. (1994). Electroless plating is plating by autocatalytic chemical reduction, in which metal ions such as nickel and copper are reduced and precipitated by a reducing agent, and the precipitation continuously proceeds to form a plating film. Electroless plating that uses nickel-phosphorus and copper is commonly used in the current industrial field. In the present invention, electroless copper plating is preferably used because it provides excellent conductivity.

An electroless copper plating solution in the present invention contains a copper source such as copper sulfate or copper chloride; a reducing agent such as formalin, glyoxylic acid, potassium tetrahydroborate, or dimethylamine borane; a copper-complexing agent such as EDTA, diethylenetriamine pentaacetic acid, rochelle salt, glycerol, meso-erythritol, adonitol, D-mannitol, D-sorbitol, dulcitol, iminodiacetic acid, trans-1,2-cyclohexanediamine tetraacetic acid, 1,3-diaminopropan-2-ol, glycol ether diamine, triisopropanolamine, or triethanolamine; and a pH adjuster such as sodium hydroxide, potassium hydroxide, or lithium hydroxide. The electroless copper plating solution can also contain additives to stabilize the plating bath and to improve the smoothness of the plating film, such as polyethylene glycol, yellow blood salt, bipyridyl, o-phenanthroline, neocuproine, thiourea, and cyanide.

There are two types of electroless plating solutions, a room-temperature plating solution for thin plating and a high-temperature plating solution for thick plating. In the present invention, the plating solution can be of either type. Electroless copper plating techniques are described in detail in "Electroless Plating Basics and Application"(edited by Electroplater's Technical Association, p. 104), for example. In the case of a room-temperature plating solution, plating is usually performed at a liquid temperature of 20°C to 30°C. In the case of a high-temperature plating solution, plating is usually performed at a liquid temperature of 50°C to 70°C. The treatment time is usually 1 to 30 minutes, preferably 3 to 20 minutes. The object of the present invention can be achieved by electroless plating under such conditions.

Prior to electroless plating, degreasing can be performed on the conductive pattern transferred to the transfer-receiving body. Degreasing is a process to remove grease and the like attached to a surface to be plated by washing the surface. Known degreasing conditions can be used. Generally, a surface to be plated is immersed in a solution containing an alkaline degreaser, a surfactant, an organic solvent, and the like at 10°C to 60°C for 1 to 10 minutes.

Prior to electroless plating, catalyst imparting can be performed on the conductive pattern transferred to the transfer-receiving body. Catalyst imparting is a process to apply a catalytic metal such as palladium, iron, cobalt, nickel, or platinum to a surface to be plated. Specifically, the catalytic metal is preferably palladium. A catalyst-imparting solution is an aqueous solution containing ions of these catalytic metals. Any counter anion that makes the metal compound water soluble may be used. Examples include sulfate ions, halogen ions, phosphate ions, and nitrate ions. The concentration of the catalytic metal in the aqueous solution is preferably 10 to 5000 mg/L, more preferably 50 to 1000 mg/L. The catalyst-imparting solution may contain a stabilizer, such as acetic acid, citric acid, lactic acid, tartaric acid, oxalic acid, butyric acid, propionic acid, formic acid, succinic acid, glutaric acid, malonic acid, malic acid, fumaric acid, adipic acid, or maleic acid. The pH of the catalyst-imparting solution is preferably 1 to 9, more preferably 1 to 4. Catalyst imparting may be performed at any temperature for any duration. Yet, the temperature is preferably 20°C to 90°C, and the duration is preferably 30 to 120 seconds in view of production efficiency.

The electrolytic plating method in the present invention may be a known method such as copper plating, nickel plating, zinc plating, or tin plating. For example, the method described in "Guidebook for Plating Technology" (edited by Tokyo Plating Material Cooperative Association, 1987) can be used. In the present invention, use of electrolytic copper plating is preferred to provide excellent conductivity.

The basic composition of an electrolytic copper plating solution in the present invention may be any known one used in common electrolytic copper plating. The basic composition and the concentration can be suitably modified and other additives can be suitably added, for example, as long as the object of the present invention is attained. In the case of copper sulfate plating, for example, a copper sulfate plating solution is an aqueous solution whose basic composition contains sulfuric acid, copper sulfate, a water-soluble chlorine compound, and a brightening agent. The plating solution may have any basic composition that is used for known copper sulfate plating.

In electrolytic copper plating, the plating temperature (liquid temperature) is suitably set according to the type of a plating bath, and is usually 10°C to 40°C, preferably 20°C to 30°C. A plating temperature of lower than 10°C reduces the conductivity of the plating solution. Thus, the current density cannot be increased during electrolysis, and the plating film growth rate slows down, which may result in low productivity. A plating temperature of higher than 40°C is not preferred because the plating solution may become unstable. Electrolytic copper plating in the present invention can use any kind of electric current, such as a DC current or a pulse periodic reverse (PPR) current. The anode current density to be applied is suitably selected according to the type of a plating bath, and is usually 0.1 to 10 A/dm², preferably 1 to 3 A/dm². An anode current density of less than 0.1 A/dm² results in too large an anode area, which is uneconomical. An anode current density of more than 10 A/dm² is not preferred because the plating solution may become unstable due to generation of oxygen from the anode during electrolysis. The plating thickness is not limited, but is preferably a thickness that ensures the conductivity required for practical use.

In the present invention, a protective layer may be provided on the transfer pattern transferred to the transfer-receiving body. Preferably, the protective layer is made of a clear coating material. The clear coating material contains a resin such as acrylic resin, urethane resin, acrylic urethane resin, acrylic silicone resin, fluororesin, epoxy resin, unsaturated polyester, alkyd resin, or melamine resin. It can also contain a UV curable resin or an electron beam curable resin. A clear coating material containing melamine resin, urethane resin, acrylic urethane resin, or acrylic silicone resin is particularly preferred in terms of easy application. These various clear coating materials are commercially available, for example, from Dai Nippon Toryo Co., Ltd., Nipponpaint Co., Kansai Paint Co., Ltd., SK Kaken Co., Ltd., Ohashi Chemical Industries Ltd., and the like.

### EXAMPLES

The present invention is described in detail below with reference to examples, but the present invention is not limited to the examples.

### (Example 1)

Water was mixed with SHALLOL® DC 902P (DKS Co. Ltd.) as a diallyldimethylammonium chloride polymer having a chloride ion as a counter ion (8 parts by mass) and fumed silica (average primary particle size: 7 nm; specific surface area: 300 m²/g) as inorganic fine particles (100 parts by mass) to prepare a pre-dispersion using a saw-tooth disperser (blade peripheral speed: 30 m/sec). The obtained pre-dispersion was treated with a high-pressure homogenizer to produce an inorganic fine particle dispersion 1 having a solid concentration of 20 mass%. The fumed silica had an average secondary particle size of 130 nm.

Using the inorganic fine particle dispersion 1, a porous layer forming coating solution 1 having the following composition was produced. The porous layer forming coating solution 1 was applied with a slide bead coater to a 100-µm thick, easy-adhesion treated polyethylene terephthalate film (Teijin Film Solutions Limited) serving as a support to a coating amount based on the solid content of 25 g/m² in terms of fumed silica, followed by drying, whereby a porous layer was formed. The porous layer had a thickness of 38 µm.

### <Porous layer forming coating solution 1>

| | |
|---|---|
| Inorganic fine particle dispersion 1 | 100 parts by mass |
| (in terms of silica solid content) | |
| Polyvinyl alcohol | 25 parts by mass |
| (degree of saponification: 88%; average degree of polymerization: 3500) | |
| Boric acid | 4 parts by mass |
| Nonionic surfactant (polyoxyethylene alkyl ether) | 0.3 parts by mass |

Water was added to adjust the concentration of components excluding water to 13 mass%.

Then, a conductivity developer coating solution 1 having the following composition was applied to the porous layer surface by a coating method using a tri-helical gravure roll, followed by drying with a dryer. The tri-helical gravure roll used was a gravure roll having a diameter of 60 mm, 90 lines per inch with a groove angle of 45 degrees, and a groove depth of 110 µm, and was used in reverse rotation. The coating amount based on the moisture content was set to 20 g/m² by adjusting the rotating speed of the tri-helical gravure roll. The applied conductivity developer coating solution 1 was absorbed into the porous layer, and the porous layer was exposed at the surface.

### <Conductivity developer coating solution 1>

| | |
|---|---|
| Sodium chloride | 0.3 parts by mass |
| Water | 99.7 parts by mass |

Then, a dissociation layer coating solution 1 having the following composition was applied to the porous layer surface by a coating method using a tri-helical gravure roll, followed by drying with a dryer, whereby a transfer sheet 1 was obtained. The tri-helical gravure roll used was a gravure roll having a diameter of 60 mm, 90 lines per inch with a groove angle of 45 degrees, and a groove depth of 110 µm, and was used in reverse rotation. The coating amount based on the moisture content was set to 20 g/m² by adjusting the rotating speed of the tri-helical gravure roll. The coating amount based on the solid content of the dissociation layer formed on the porous layer was 0.6 g/m².

### <Dissociation layer coating solution 1>

| | |
|---|---|
| 20 Mass% slurry of colloidal silica | 15 parts by mass |
| (Quartron PL-3L from Fuso Chemical Co., primary particle size: 35 nm) Ltd.; average | |
| Water | 85 parts by mass |

A 50 mm × 50 mm solid pattern (planar pattern) was printed on the transfer sheet 1 to form a conductive pattern thereon, using a piezo inkjet printer containing a silver nano ink (NBSIJ-MU01 from Mitsubishi Paper Mills Limited; silver concentration: 15 mass%). The discharge rate of the silver nano ink was 23 ml/m², and the thickness of the conductive pattern was 0.8 µm.

Using a roll laminator, the conductive pattern-formed surface of the transfer sheet 1 was pressure-bonded to a transfer-receiving body in the form of carbon fiber reinforced resin molding prepreg (Torayca® F6343B from Toray Industries, Inc., containing an epoxy resin as a thermosetting resin and having an adhesive force at 25°C of 0.25 N/25 mm as measured at a peeling angle of 180 degrees according to JIS Z 0237), at a roll temperature of 25°C, a pressure of 10 N/cm², and a rate of 0.3 m/min (pressure-bonding time of 1 second). Then, the transfer sheet 1 was peeled off. Subsequently, the transfer-receiving body was heated at 140°C for 30 minutes, whereby a pattern-transferred product of Example 1 having a conductive pattern was obtained. The surface of the resulting pattern-transferred product was not adhesive at room temperature.

### (Example 2)

Water was mixed with nitric acid (2.5 parts by mass) and alumina hydrate (average primary particle size: 15 nm) (100 parts by mass) to prepare an inorganic fine particle dispersion 2 having a solid concentration of 30 mass%, using a saw-tooth disperser. The alumina hydrate dispersed in the inorganic fine particle dispersion 2 had an average secondary particle size of 160 nm.

Using the inorganic fine particle dispersion 2, a porous layer forming coating solution 2 having the following composition was produced. The porous layer forming coating solution 2 was applied with a slide bead coater to a 100-µm thick, easy-adhesion treated polyethylene terephthalate film (Teijin Film Solutions Limited) serving as a support to a coating amount based on the solid content of 32 g/m² in terms of alumina hydrate, followed by drying, whereby a porous layer was formed. The porous layer had a thickness of 42 µm.

### <Porous layer forming coating solution 2>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |

Water was added to adjust the concentration of components excluding water to 16 mass%.

Then, the conductivity developer coating solution 1 was applied to the porous layer surface as in Example 1. The applied conductivity developer coating solution 1 was absorbed into the porous layer, and the porous layer was exposed at the surface.

Then, a dissociation layer coating solution 2 having the following composition was applied to the porous layer surface by a coating method using a tri-helical gravure roll, followed by drying with a dryer, whereby a transfer sheet 2 was obtained. The tri-helical gravure roll used was a gravure roll having a diameter of 60 mm, 90 lines per inch with a groove angle of 45 degrees, and a groove depth of 110 µm, and was used in reverse rotation. The coating amount based on the moisture content was set to 20 g/m² by adjusting the rotating speed of the tri-helical gravure roll. The coating amount based on the solid content of the dissociation layer formed on the porous layer was 0.4 g/m².

### <Dissociation layer coating solution 2>

| | |
|---|---|
| 40 mass% slurry of colloidal silica | 5 parts by mass |
| (SNOWTEX ZL available from Nissan Chemical Corporation; average primary particle size: 80 nm) | |
| Water | 95 parts by mass |

A 50 mm × 50 mm solid pattern was printed on the transfer sheet 2 to form a conductive pattern thereon, using a piezo inkjet printer containing a silver nano ink (NBSIJ-MU01 from Mitsubishi Paper Mills Limited; silver concentration: 15 mass%). The discharge rate of the silver nano ink was 23 ml/m², and the thickness of the conductive pattern was 0.8 µm.

Using a roll laminator, the conductive pattern-formed surface of the transfer sheet 2 was pressure-bonded to a transfer-receiving body in the form of an epoxy resin sheet (DRS-028 from Sanyu Rec. Ltd., containing an epoxy resin as a thermosetting resin and having an adhesive force at 25°C of 0.9 N/25 mm as measured at a peeling angle of 180 degrees according to JIS Z 0237), at a roll temperature of 25°C, a pressure of 10 N/cm², and a rate of 0.3 m/min (pressure-bonding time of 1 second). Then, the transfer sheet 2 was peeled off. Subsequently, the transfer-receiving body was heated at 150°C for 60 minutes, whereby a pattern-transferred product of Example 2 having a conductive pattern was obtained. The surface of the resulting pattern-transferred product was not adhesive at room temperature.

### (Example 3)

A pattern-transferred product of Example 3 was obtained as in Example 2 using a transfer sheet produced as in Example 2, except that a dissociation layer coating solution 3 having the following composition was used instead of the dissociation layer coating solution 2 of Example 2. The coating amount based on the solid content of the dissociation layer formed on the porous layer was 0.6 g/m². The surface of the resulting pattern-transferred product was not adhesive at room temperature.

### <Dissociation layer coating solution 3>

| | |
|---|---|
| 20 Mass% sol of zirconium oxide | 15 parts by mass |
| (Zr 100/20 from Nyacol Nano Technologies, Inc.; average primary particle size: 100 nm) | |
| Water | 85 parts by mass |

### (Example 4)

A pattern-transferred product of Example 4 was obtained as in Example 3, except that the transfer-receiving body was changed from the epoxy resin sheet (DRS-028 from Sanyu Rec. Ltd.) to prepreg (Torayca F6343B from Toray Industries, Inc.) and that the transfer-receiving body was heated at 140°C for 30 minutes. The surface of the resulting pattern-transferred product was not adhesive at room temperature.

### (Example 5)

A pattern-transferred product of Example 5 was obtained as in Example 2 using a transfer sheet produced as in Example 2, except that a dissociation layer coating solution 4 having the following composition was used instead of the dissociation layer coating solution 2 of Example 2. The coating amount based on the solid content of the dissociation layer formed on the porous layer was 0.2 g/m². The surface of the resulting pattern-transferred product was not adhesive at room temperature.

### <Dissociation layer coating solution 4>

| | |
|---|---|
| 60 Mass% aqueous dispersion of fluororesin | |
| | 1.7 parts by mass |
| (PTFE D-210C from Daikin Industries, Ltd.; average primary particle size: 220 nm) | |
| Water | 98.2 parts by mass |
| Anionic surfactant | 0.05 parts by mass |
| (sodium polyoxyethylene lauryl ether sulfate) | |

### (Example 6)

A pattern-transferred product of Example 6 was obtained as in Example 5, except that the transfer-receiving body was changed from the epoxy resin sheet (DRS-028 from Sanyu Rec. Ltd.) to prepreg (Torayca F6343B from Toray Industries, Inc.) and that the transfer-receiving body was heated at 140°C for 30 minutes. The surface of the resulting pattern-transferred product was not adhesive at room temperature.

### (Comparative Example 1)

Prepreg (Torayca F6343B from Toray Industries, Inc.) was pre-heated at 140°C for 30 minutes. Subsequently, a 50 mm × 50 mm solid pattern was printed on the surface of the prepreg with a silver paste (DOTITE FA-333 from Fujikura Kasei Co., Ltd.) using a screen printer, followed by further heating at 120°C for 10 minutes. Thus, a pattern-formed member of Comparative Example 1 was obtained. The surface of the resulting pattern-formed member was not adhesive at room temperature.

### (Comparative Example 2)

An epoxy resin sheet (DRS-028 from Sanyu Rec. Ltd.) was pre-heated at 150°C for 60 minutes. Subsequently, a 50 mm × 50 mm solid pattern was printed on the surface of the epoxy resin sheet with a silver paste (DOTITE FA-333 from Fujikura Kasei Co., Ltd.) using a screen printer, followed by further heating at 120°C for 10 minutes. Thus, a pattern-formed member of Comparative Example 2 was obtained. The surface of the resulting pattern-formed member was not adhesive at room temperature.

### (Comparative Example 3)

Prepreg (Torayca F6343B from Toray Industries, Inc.) was pre-heated at 140°C for 30 minutes. The conductive pattern produced on the transfer sheet 1 in Example 1 was transferred to one side of a double-sided adhesive tape (No. 5600 from Nitto Denko Corporation, having an adhesive force at 25°C of 7.5 N/25 mm as measured at a peeling angle of 180 degrees according to JIS Z 0237). Subsequently, an adhesive surface (on the side without the conductive pattern) of the double-sided adhesive tape having the conductive pattern transferred thereto was attached to a heat-treated transfer-receiving body. Thus, a pattern-formed member of Comparative Example 3 was obtained. The surface of the resulting pattern-formed member was adhesive at room temperature because of the double-sided adhesive tape thereon.

### (Comparative Example 4)

An epoxy resin sheet (DRS-028 from Sanyu Rec. Ltd.) was pre-heated at 150°C for 60 minutes. The conductive pattern produced on the transfer sheet 2 in Example 2 was transferred to one side of a double-sided adhesive tape (No. 5600 from Nitto Denko Corporation). Subsequently, adhesive surface (on the side without the conductive pattern) of the double-sided adhesive tape having the conductive pattern transferred thereto was attached to the heat-treated transfer-receiving body. Thus, a pattern-formed member of Comparative Example 4 was obtained. The surface of the resulting pattern-formed member was adhesive at room temperature because of the double-sided adhesive tape thereon.

The following evaluations were performed on the resulting pattern-transferred products of Examples 1 to 6 and the pattern-formed members of Comparative Examples 1 to 4. Since the transfer patterns of the pattern-transferred products of Examples 1 to 6 were metallic patterns with metallic gloss, they were also usable as metallic decorative members.

### <Evaluation of conductivity>

The sheet resistance value of the conductive pattern of each member was measured using a measuring device (Loresta® -GP from Dia Instruments Co., Ltd.). Table 1 shows the results.

### <Evaluation of adhesion>

The adhesion of the conductive pattern of each member to the transfer-receiving body was determined by the cross-cut test specified in JIS K 5600-5-6. The adhesion was evaluated in six levels from 0 to 5, as described in JIS K 5600-5-6. 0: None of the squares peeled off. 1: The extent of peeling off was 5% or less. 2: The extent of peeling off was more than 5% and 15% or less. 3: The extent of peeling off was more than 15% and 35% or less. 4: The extent of peeling off was more than 35% and 65% or less. 5: The extent of peeling off was more than 65%. Table 1 shows the results.

**[Table 1]**

| | Conductivity (Ω/□) | Adhesion |
|---|---|---|
| Example 1 | 0.150 | 0 |
| Example 2 | 0.150 | 0 |
| Example 3 | 0.150 | 0 |
| Example 4 | 0.150 | 0 |
| Example 5 | 0.250 | 0 |
| Example 6 | 0.250 | 0 |
| Comparative Example 1 | 0.200 | 3 |
| Comparative Example 2 | 0.200 | 3 |
| Comparative Example 3 | 0.150 | 1 |
| Comparative Example 4 | 0.150 | 1 |

### (Example 7)

After the step of peeling off the transfer sheet from the transfer-receiving body in Example 1, the pattern transferred surface of the transfer-receiving body was degreased. Then, electroless copper plating was performed. Degreasing was performed at 60°C for 1 minute in a treatment solution prepared by adding CLEANER 160 from Meltex Inc. to 50 g/L. Electroless copper plating was performed at 40°C for 10 minutes in an electroless copper plating solution prepared to have the following composition. After degreasing and electroless copper plating, the transfer-receiving body was washed with water. After plating, the transfer-receiving body was heated at 140°C for 30 minutes, whereby a pattern-transferred product of Example 7 was obtained. The surface of the resulting pattern-transferred product was not adhesive at room temperature.

### <Electroless copper plating solution>

| | |
|---|---|
| Copper sulfate pentahydrate | 10 g |
| Formaldehyde (37 mass% aqueous solution) | 20 ml |
| Sodium hydroxide | 10 g |
| EDTA·2Na·2H₂O | 25 g |

These components were dissolved in water to give a total amount of 1 kg.

### (Example 8)

A pattern-transferred product of Example 8 was obtained as in Example 7, except that electrolytic copper plating was performed at 25°C for 4 minutes and 30 seconds (current density: 2 A/dm²) in a copper sulfate plating solution prepared to have the following composition in the plating step. The surface of the resulting pattern-transferred product was not adhesive at room temperature.

### <Copper sulfate plating solution>

| | |
|---|---|
| Copper sulfate pentahydrate | 120 g |
| 12 normal sulfuric acid | 120 g |
| Water | 760 g |

### (Example 9)

After the step of peeling off the transfer sheet from the transfer-receiving body in Example 2, the pattern-transferred surface of the transfer-receiving body was subjected to degreasing and electroless copper plating as in Example 7. After plating, the transfer-receiving body was heated at 150°C for 60 minutes, whereby a pattern-transferred product of Example 9 was obtained. The surface of the resulting pattern-transferred product was not adhesive at room temperature.

### (Example 10)

After the step of peeling off the transfer sheet from the transfer-receiving body in Example 3, the pattern-transferred surface of the transfer-receiving body was subjected to degreasing and electroless copper plating as in Example 7. After plating, the transfer-receiving body was heated at 150°C for 60 minutes, whereby a pattern-transferred product of Example 10 was obtained. The surface of the resulting pattern-transferred product was not adhesive at room temperature.

### (Example 11)

After the step of peeling off the transfer sheet from the transfer-receiving body in Example 5, the pattern transferred surface of the transfer-receiving body was subjected to degreasing and electroless copper plating as in Example 7. After plating, the transfer-receiving body was heated at 150°C for 60 minutes, whereby a pattern-transferred product of Example 11 was obtained. The surface of the resulting pattern-transferred product was not adhesive at room temperature.

### (Example 12)

A pattern-transferred product of Example 12 was obtained as in Example 8, except that the transfer-receiving body was first heated and then plated, instead of being plated and then heated, after the step of peeling off the transfer sheet from the transfer-receiving body. The surface of the resulting pattern-transferred product was not adhesive at room temperature.

### (Comparative Example 5)

A pattern-formed member of Comparative Example 5 was obtained by performing degreasing and electroless copper plating as in Example 7 on the pattern-formed surface of the pattern-formed member of Comparative Example 3. The surface of the resulting pattern-formed member was adhesive at room temperature because of the double-sided adhesive tape thereon.

The following evaluations were performed on the resulting pattern-transferred products of Examples 7 to 12 and the pattern-formed member of Comparative Example 5.

### <Evaluation of conductivity>

The sheet resistance value of the conductive pattern of each member was measured using a measuring device (Loresta-GP from Dia Instruments Co., Ltd.). The results are as follows.
Example 7: 0.037 Ω/□
Example 8: 0.008 Ω/□
Example 9: 0.036 Ω/□
Example 10: 0.040 Ω/□
Example 11: 0.045 Ω/□
Example 12: 0.010 Ω/□
Comparative Example 5: 0.040 Ω/□

### <Evaluation of adhesion>

The adhesion of the conductive pattern of each member to the transfer-receiving body was determined by the cross-cut test specified in JIS K 5600-5-6. A portion with the conductive pattern of each member was cross-cut at 2-mm intervals to give a total of 25 squares (5 squares × 5 squares). CELLOTAPE® (24 mm width) from Nichiban Co., Ltd. was attached to the portion and rapidly peeled off. Unpeeled squares were observed for evaluation. The results are as follows.
Example 7: Adhesion was good with no squares peeled off.
Example 8: Adhesion was good with no squares peeled off.
Example 9: Adhesion was good with no squares peeled off.
Example 10: Adhesion was good with no squares peeled off.
Example 11: Adhesion was good with no squares peeled off.
Example 12: The conductive pattern formed with the silver nano ink transferred from the transfer sheet was retained, but the silver plating layer formed by plating was partially peeled off with the tape.
Comparative Example 5: Adhesion was poor with some squares peeled off.

### (Example 13)

A liquid solder resist "DSR-330S32-21" from Tamura Corporation was used to form a solder resist layer. For use in pattern transfer, the solder resist layer was mixed with DSR-330S32-21 containing a main agent and a curing agent, and the mixture was applied using an applicator to a SUS 304 stainless steel plate serving as a support, and dried at 70°C for 30 minutes. The solder resist layer had an adhesive force at 25°C of 0.2 to 10 N/25 mm as measured at a peeling angle of 180 degrees according to JIS Z 0237.

The conductive pattern was transferred to the solder resist layer using a roll laminator. The conductive pattern-formed surface of the pattern-formed transfer sheet 1 produced in Example 1 was pressure-bonded to the solder resist layer at a roll temperature of 25°C, a pressure of 10 N/cm², and a rate of 0.3 m/min (pressure-bonding time of 1 second). Then, the transfer sheet was peeled off. Subsequently, the solder resist layer was heated at 180°C for 60 minutes, whereby a pattern-transferred product of Example 13 having a conductive pattern was obtained. The surface of the resulting pattern-transferred product was not adhesive at room temperature.

### (Example 14)

A pattern-transferred product of Example 14 was obtained as in Example 13, except that the solder resist layer was a solder resist in the form of a dry film "PFR-800 AUS410" from Taiyo Ink Mfg. Co., Ltd., which was thermally pressure-bonded to a SUS 304 stainless steel plate serving as a support. For pattern transfer, the solder resist layer had an adhesive force at 25°C of 0.2 to 10 N/25 mm as measured at a peeling angle of 180 degrees according to JIS Z 0237. The surface of the resulting pattern-transferred product was not adhesive at room temperature.

### (Comparative Example 6)

A 50 mm × 50 mm solid pattern was screen printed on a surface of the solder resist layer used in Example 13 with a silver paste (DOTITE FA-333 from Fujikura Kasei Co., Ltd.), followed by heating at 120°C for 10 minutes. Subsequently, further heating was performed at 180°C for 60 minutes, whereby a pattern-formed member of Comparative Example 6 was obtained. The surface of the resulting pattern-formed member was not adhesive at room temperature.

### (Comparative Example 7)

A 50 mm × 50 mm solid pattern was screen printed on a surface of the solder resist layer used in Example 14 with a silver paste (DOTITE FA-333 from Fujikura Kasei Co., Ltd.), followed by heating at 120°C for 10 minutes. Subsequently, further heating was performed at 180°C for 60 minutes, whereby a pattern-formed member of Comparative Example 7 was obtained. The surface of the resulting pattern-formed member was not adhesive at room temperature.

The following evaluations were performed on the resulting pattern-transferred products of Examples 13 and 14 and the pattern-formed members of Comparative Examples 6 and 7.

### <Evaluation of adhesion>

The adhesion of the conductive pattern of each member to the transfer-receiving body was determined by the cross-cut test specified in JIS K 5600-5-6. A portion with the conductive pattern of each member was cross-cut at 1-mm intervals to give a total of 100 squares (10 squares × 10 squares). CELLOTAPE (24 mm width) from Nichiban Co., Ltd. was attached to the portion and rapidly peeled off. The state of unpeeled squares was observed for evaluation. The results are as follows.
Example 13: Adhesion was good with no squares peeled off.
Example 14: Adhesion was good with no squares peeled off.
Comparative Example 6: Adhesion was poor with some squares peeled off.
Comparative Example 7: Adhesion was poor with some squares peeled off.

### (Example 15)

After the step of peeling off the transfer sheet from the transfer-receiving body in Example 13, the pattern transferred surface of the transfer-receiving body was sequentially subjected to degreasing, catalyst imparting, and electroless copper plating. Degreasing was performed at 60°C for 1 minute in a treatment solution prepared by adding CLEANER 160 from Meltex Inc. to 50 g/L. Catalyst imparting was performed at 25°C for 2 minutes in a treatment solution prepared by adding Activator 350 from Meltex Inc. to give a palladium concentration of 100 ppm. Electroless copper plating was performed at 50°C for 10 minutes in a treatment solution prepared by diluting "0MELPLATE® CU-5100" from Meltex Inc. for thick electroless copper plating to a standard concentration. After degreasing, catalyst imparting, and electroless copper plating, the transfer-receiving body was washed with water. The conductive pattern after plating had a thickness of 1.8 µm. After plating, the transfer-receiving body was heated at 180°C for 60 minutes, whereby a pattern-transferred product of Example 15 was obtained. The surface of the resulting pattern-transferred product was not adhesive at room temperature.

### (Example 16)

After the step of peeling off the transfer sheet from the transfer-receiving body in Example 14, the pattern-transferred surface of the transfer-receiving body was sequentially subjected to degreasing and electroless copper plating. Degreasing was performed as in Example 15. Electrolytic copper plating was performed at 25°C for 3 minutes (current density: 2 A/dm²) in a copper sulfate plating solution prepared to have the following composition. After degreasing, catalyst imparting, and electrolytic copper plating, the transfer-receiving body was washed with water. The thickness of the conductive pattern after plating was 1.8 µm. After plating, the transfer-receiving body was heated at 180°C for 60 minutes, whereby a pattern-transferred product of Example 16 was obtained. The surface of the resulting pattern-transferred product was not adhesive at room temperature.

### <Copper sulfate plating solution>

| | |
|---|---|
| Copper sulfate pentahydrate | 75 g |
| 12 normal sulfuric acid | 190 g |
| Gloss agent | appropriate amount |
| (COPPER GLEAM® CLX from Rohm and Haas Company) | |
| Chloride ion | 50 mg |

Water was added to adjust the total amount to 1000 ml.

### (Comparative Example 8)

A 50 mm × 50 mm solid pattern was screen printed on a surface of the solder resist layer used in Example 13 using a piezo inkjet printer containing a silver nano ink (NBSIJ-MU01 from Mitsubishi Paper Mills Limited; silver concentration: 15 mass%). Subsequently, the solder resist layer was heated at 180°C for 1 hour, whereby a pattern-formed member of Comparative Example 8 was obtained. The discharge rate of the silver nano ink was 23 ml/m², and the thickness of the conductive pattern was 0.9 µm. The surface of the resulting pattern-formed member was not adhesive at room temperature.

The following evaluations were performed on the resulting pattern-transferred products of Examples 15 and 16 and the pattern-formed member of Comparative Example 8.

### <Evaluation of conductivity>

The sheet resistance value of the conductive pattern of each member was measured using a measuring device (Loresta-GP from Dia Instruments Co., Ltd.). The results are as follows.
Example 15: 0.022 Ω/□
Example 16: 0.015 Ω/□
Comparative Example 8: 0.110 Ω/□

### <Evaluation of adhesion>

The adhesion of the conductive pattern of each member to the transfer-receiving body was determined by the cross-cut test specified in JIS K 5600-5-6. A portion with the conductive pattern of each member was cross-cut at 1-mm intervals to give a total of 100 squares (10 squares × 10 squares). CELLOTAPE (24 mm width) from Nichiban Co., Ltd. was attached to the portion and rapidly peeled off. Unpeeled squares were observed for evaluation. The results are as follows.
Example 15: Adhesion was good with no squares peeled off.
Example 16: Adhesion was good with no squares peeled off.
Comparative Example 8: Adhesion was poor with some squares peeled off.

### (Example 17)

The transfer-receiving body that is not adhesive at room temperature and that becomes adhesive when heated was LAZ-7752 from Sumitomo Bakelite Co., Ltd. After pre-heating the transfer-receiving body at 80°C for 1 hour, the adhesive force of the transfer-receiving body at 50°C was measured using a SUS 304 stainless steel plate whose temperature was adjusted to 50°C, at a peeling angle of 180 degrees according to JIS Z 0237. The adhesive force was 1.1 N/25 mm. The adhesive force of the transfer-receiving body at 25°C prior to pre-heating was 0.03 N/25 mm.

The transfer-receiving body was LAZ-7752 from Sumitomo Bakelite Co., Ltd. For pattern transfer, the transfer-receiving body was used with a SUS 304 stainless steel plate serving as a support thermally pressure-bonded thereto. The conductive pattern was transferred to the transfer-receiving body using a roll laminator whose temperature was adjusted to a 50°C. The conductive pattern-formed surface of the pattern-formed transfer sheet 1 produced in Example 1 was pressure-bonded to the transfer-receiving surface of the transfer-receiving body that was pre-heated at 80°C for 1 hour, at a transfer-receiving body temperature of 50°C, a pressure of 20 N/cm², and a rate of 0.3 m/min (pressure-bonding time of 1 second). After naturally cooling to room temperature, the transfer sheet was peeled off. Subsequently, heating was performed at 180°C for 60 minutes, whereby a pattern-transferred product of Example 17 having a conductive pattern was obtained. The surface of the resulting pattern-transferred product was not adhesive at room temperature.

### (Example 18)

A pattern-transferred product of Example 18 was obtained as in Example 17, except that the roll temperature of the laminator was changed to 70°C. The temperature of the transfer-receiving body during pattern transfer was 70°C. The surface of the resulting pattern-transferred product was not adhesive at room temperature. The adhesive force of the transfer-receiving body at 70°C was measured as in Example 17, except that the temperature of the SUS 304 stainless steel plate was adjusted to 70°C. The adhesive force was 4.9 N/25 mm.

### (Example 19)

A pattern-transferred product of Example 19 was obtained as in Example 18, except that the pattern-formed transfer sheet 2 produced in Example 2 was used instead of the transfer sheet 1 as a conductive pattern-formed transfer sheet for use in pattern transfer. The surface of the resulting pattern-transferred product was not adhesive at room temperature.

### (Example 20)

A pattern-transferred product of Example 20 was obtained as in Example 18, except that the pattern-formed transfer sheet produced in Example 3 was used instead of the transfer sheet 1 as a conductive pattern-formed transfer sheet for use in pattern transfer. The surface of the resulting pattern-transferred product was not adhesive at room temperature.

### (Example 21)

A pattern-transferred product of Example 21 was obtained as in Example 18, except that the pattern-formed transfer sheet produced in Example 5 was used instead of the transfer sheet 1 as a conductive pattern-formed transfer sheet for use in pattern transfer. The surface of the resulting pattern-transferred product was not adhesive at room temperature.

### (Comparative Example 9)

A SUS 304 stainless steel plate serving as a support was heat-bonded to LAZ-7752 from Sumitomo Bakelite Co., Ltd., followed by heating at 80°C for 1 hour. Subsequently, a 50 mm × 50 mm solid pattern was printed on the surface of LAZ-7752 with a silver paste (DOTITE FA-333 from Fujikura Kasei Co., Ltd.) using a screen printer, followed by further heating at 120°C for 10 minutes. Subsequently, further heating was performed at 180°C for 60 minutes, whereby a pattern-formed member of Comparative Example 9 was obtained. The surface of the resulting pattern-formed member was not adhesive at room temperature.

The following evaluations were performed on the resulting pattern-transferred products of Examples 17 to 21 and the pattern-formed member of Comparative Example 9.

### <Evaluation of conductivity>

The sheet resistance value of the conductive pattern of each member was measured using a measuring device (Loresta-GP from Dia Instruments Co., Ltd.). The results are as follows.
Example 17: 0.150 Ω/□
Example 18: 0.150 Ω/□
Example 19: 0.150 Ω/□
Example 20: 0.150 Ω/□
Example 21: 0.250 Ω/□
Comparative Example 9: 0.200 Ω/□

### <Evaluation of adhesion>

The adhesion of the conductive pattern of each member to the transfer-receiving body was determined by the cross-cut test specified in JIS K 5600-5-6. A portion with the conductive pattern of each member was cross-cut at 1-mm intervals to give a total of 100 squares (10 squares × 10 squares). CELLOTAPE (24 mm width) from Nichiban Co., Ltd. was attached to the portion and rapidly peeled off. Unpeeled squares were observed for evaluation. The results are as follows.
Example 17: Adhesion was good with no squares peeled off.
Example 18: Adhesion was good with no squares peeled off.
Example 19: Adhesion was good with no squares peeled off.
Example 20: Adhesion was good with no squares peeled off.
Example 21: Adhesion was good with no squares peeled off.
Comparative Example 9: Adhesion was poor with some squares peeled off.

### (Example 22)

After the step of peeling off the transfer sheet from the transfer-receiving body in Example 17, the pattern-transferred surface of the transfer-receiving body was sequentially subjected to degreasing, catalyst imparting, and electroless copper plating. Degreasing, catalyst imparting, electroless copper plating, and washing with water were performed as in Example 15. The thickness of the conductive pattern after plating was 1.8 µm. After plating, the transfer-receiving body was heated at 180°C for 60 minutes, whereby a pattern-transferred product of Example 22 was obtained. The surface of the resulting pattern-transferred product was not adhesive at room temperature.

### (Example 23)

After the step of peeling off the transfer sheet from the transfer-receiving body in Example 18, the pattern-transferred surface of the transfer-receiving body was sequentially subjected to degreasing and electroless copper plating. Degreasing, electrolytic copper plating, and washing with water were performed as in Example 16. The thickness of the conductive pattern after plating was 1.8 µm. After plating, the transfer-receiving body was heated at 180°C for 60 minutes, whereby a pattern-transferred product of Example 23 was obtained. The surface of the resulting pattern-transferred product was not adhesive at room temperature.

### (Example 24)

A pattern-transferred product of Example 24 was obtained as in Example 22, except that the transfer-receiving body was first heated and then plated, instead of being plated and then heated, after the step of peeling off the transfer sheet from the transfer-receiving body. The surface of the resulting pattern-transferred product was not adhesive at room temperature.

The following evaluations were performed on the resulting pattern-transferred products of Examples 22 to 24.

### <Evaluation of conductivity>

The sheet resistance value of the conductive pattern of each member was measured using a measuring device (Loresta-GP from Dia Instruments Co., Ltd.). The results are as follows.
Example 22: 0.022 Ω/□
Example 23: 0.015 Ω/□
Example 24: 0.045 Ω/□

### <Evaluation of adhesion>

The adhesion of the conductive pattern of each member to the transfer-receiving body was determined by the cross-cut test specified in JIS K 5600-5-6. A portion with the conductive pattern of each member was cross-cut at 1-mm intervals to give a total of 100 squares (10 squares × 10 squares). CELLOTAPE (24 mm width) from Nichiban Co., Ltd. was attached to the portion and rapidly peeled off. Unpeeled squares were observed for evaluation. The results are as follows.
Example 22: Adhesion was good with no squares peeled off.
Example 23: Adhesion was good with no squares peeled off.
Example 24: The conductive pattern formed with the silver nano ink transferred from the transfer sheet was retained, but the silver plating layer formed by plating was completely peeled off with the tape.

### (Example 25)

The transfer-receiving body that is not adhesive at room temperature and that becomes adhesive when heated was an acrylic resin plate (COMOGLAS® P, clear, 1 mm thick, from Kuraray Co., Ltd.). The adhesive force of the transfer-receiving body at 150°C was measured using a SUS 304 stainless steel plate whose temperature was adjusted to 150°C, at a peeling angle of 180 degrees according to JIS Z 0237. The adhesive force was 2.5 N/25 mm.

The conductive pattern was transferred to the transfer-receiving body using a roll laminator. The conductive pattern-formed surface of the pattern-formed transfer sheet 1 produced in Example 1 was pressure-bonded to the transfer-receiving surface of the transfer-receiving body at a roll temperature of 150°C, a pressure of 200 N/cm², and a rate of 0.3 m/min (pressure-bonding time of 1 second). After naturally cooling to room temperature, the transfer sheet was peeled off. Thus, a pattern-transferred product of Example 25 having a conductive pattern was obtained. The surface of the resulting pattern-transferred product was not adhesive at room temperature.

### (Example 26)

A pattern-transferred product of Example 26 having a conductive pattern was obtained as in Example 25, except that the transfer-receiving body that is not adhesive at room temperature and that becomes adhesive when heated was an ABS resin plate (ABS Sheet F-4626, black, 1 mm thick, from Sekon Industry Inc.). The surface of the resulting pattern-transferred product was not adhesive at room temperature. The adhesive force of the transfer-receiving body at 150°C was measured using a SUS 304 stainless steel plate whose temperature was adjusted to 150°C, at a peeling angle of 180 degrees according to JIS Z 0237. The adhesive force was 2.3 N/25 mm.

### (Example 27)

A pattern-transferred product of Example 27 was obtained as in Example 25, except that the pattern-formed transfer sheet 2 produced in Example 2 was used instead of the transfer sheet 1 as a conductive pattern-formed transfer sheet for use in pattern transfer. The surface of the resulting pattern-transferred product was not adhesive at room temperature.

### (Example 28)

A conductive member of Example 28 was obtained as in Example 27, except that the transfer-receiving body was changed to an ABS resin plate (ABS Sheet F-4626, black, from Sekon Industry Inc.). The surface of the resulting pattern-transferred product was not adhesive at room temperature.

### (Example 29)

A pattern-transferred product of Example 29 was obtained as in Example 25, except that the pattern-formed transfer sheet produced in Example 3 was used instead of the transfer sheet 1 as a conductive pattern-formed transfer sheet for use in pattern transfer. The surface of the resulting pattern-transferred product was not adhesive at room temperature.

### (Example 30)

A conductive member of Example 30 was obtained as in Example 29, except that the transfer-receiving body was changed to an ABS resin plate (ABS Sheet F-4626, black, from Sekon Industry Inc.). The surface of the resulting pattern-transferred product was not adhesive at room temperature.

### (Example 31)

A pattern-transferred product of Example 31 was obtained as in Example 25, except that the pattern-formed transfer sheet produced in Example 5 was used instead of the transfer sheet 1 as a conductive pattern-formed transfer sheet for use in pattern transfer. The surface of the resulting pattern-transferred product was not adhesive at room temperature.

### (Example 32)

A conductive member of Example 32 was obtained as in Example 31, except that the transfer-receiving body was changed to an ABS resin plate (ABS Sheet F-4626, black, from Sekon Industry Inc.). The surface of the resulting pattern-transferred product was not adhesive at room temperature.

### (Comparative Example 10)

A 50 mm × 50 mm solid pattern was printed on a surface of an acrylic resin plate (COMOGLAS P, clear, from Kuraray Co., Ltd.) with a silver paste (DOTITE FA-333 from Fujikura Kasei Co., Ltd.) using a screen printer, followed by heating at 120°C for 10 minutes. Thus, a pattern-formed member of Comparative Example 10 was obtained. The surface of the resulting pattern-formed member was not adhesive at room temperature.

### (Comparative Example 11)

A pattern-formed member of Comparative Example 11 was obtained as in Comparative Example 10, except that the transfer-receiving body was changed to an ABS resin plate (ABS Sheet F-4626, black, from Sekon Industry Inc.). The surface of the resulting pattern-formed member was not adhesive at room temperature.

### (Comparative Example 12)

The conductive pattern produced of the pattern-formed transfer sheet 1 produced in Example 1 was transferred to one side of a double-sided adhesive tape (No. 5600 from Nitto Denko Corporation). Subsequently, an adhesive surface (on the side without the conductive pattern) of the double-sided adhesive tape having the conductive pattern transferred thereto was attached to an acrylic resin plate (COMOGLAS P Clear from Kuraray Co., Ltd.). Thus, a pattern-formed member of Comparative Example 12 was obtained. The surface of the resulting pattern-formed member was adhesive at room temperature because of the double-sided adhesive tape thereon.

### (Comparative Example 13)

A pattern-formed member of Comparative Example 13 was obtained as in Comparative Example 12, except that the transfer-receiving body was changed to an ABS resin plate (ABS Sheet F-4626, black, from Sekon Industry Inc.). The surface of the resulting pattern-formed member was adhesive at room temperature because of the double-sided adhesive tape thereon.

The resulting pattern-transferred products of Examples 25 to 32 and the resulting pattern-formed members of Comparative Examples 10 to 13 were evaluated in the same manner as in the evaluation of the pattern-transferred products of Examples 1 to 6 and the pattern-formed members of Comparative Examples 1 to 4. Table 2 shows the results. Since the transfer patterns of the pattern-transferred products of Examples 25 to 32 were metallic patterns with metallic gloss, they were also usable as metallic decorative members.

**[Table 2]**

| | Conductivity (Ω/□) | Adhesion |
|---|---|---|
| Example 25 | 0.150 | 0 |
| Example 26 | 0.150 | 0 |
| Example 27 | 0.150 | 0 |
| Example 28 | 0.150 | 0 |
| Example 29 | 0.150 | 0 |
| Example 30 | 0.150 | 0 |
| Example 31 | 0.250 | 0 |
| Example 32 | 0.250 | 0 |
| Comparative Example 10 | 0.200 | 3 |
| Comparative Example 11 | 0.200 | 2 |
| Comparative Example 12 | 0.150 | 1 |
| Comparative Example 13 | 0.150 | 1 |

### (Example 33)

A pattern-transferred product of Example 33 was obtained by performing degreasing and electroless copper plating as in Example 7 on the pattern-transferred surface of the pattern-transferred product of Example 25. The surface of the resulting pattern-transferred product was not adhesive at room temperature.

### (Example 34)

A pattern-transferred product of Example 34 was obtained by performing degreasing and electrolytic copper plating as in Example 8 on the pattern-transferred surface of the pattern-transferred product of Example 25. The surface of the resulting pattern-transferred product was not adhesive at room temperature.

### (Example 35)

A conductive member of Example 35 was obtained as in Example 33, except that the transfer-receiving body was changed to an ABS resin plate (ABS Sheet F-4626, black, from Sekon Industry Inc.). The surface of the resulting pattern-transferred product was not adhesive at room temperature.

### (Example 36)

A pattern-transferred product of Example 36 was obtained as in Example 33, except that the pattern-formed transfer sheet 2 produced in Example 2 was used instead of the transfer sheet 1 as a conductive pattern-formed transfer sheet for use in pattern transfer. The surface of the resulting pattern-transferred product was not adhesive at room temperature.

### (Example 37)

A pattern-transferred product of Example 37 was obtained as in Example 33, except that the pattern-formed transfer sheet produced in Example 3 was used instead of the transfer sheet 1 as a conductive pattern-formed transfer sheet for use in pattern transfer. The surface of the resulting pattern-transferred product was not adhesive at room temperature.

### (Example 38)

A pattern-transferred product of Example 38 was obtained as in Example 33, except that the pattern-formed transfer sheet produced in Example 5 was used instead of the transfer sheet 1 as a conductive pattern-formed transfer sheet for use in pattern transfer. The surface of the resulting pattern-transferred product was not adhesive at room temperature.

### (Comparative Example 14)

A pattern-formed member of Comparative Example 14 was obtained by performing degreasing and electroless copper plating as in Example 7 on the pattern-formed surface of the pattern-formed member of Comparative Example 12. The surface of the resulting pattern-formed member was adhesive at room temperature because of the double-sided adhesive tape thereon.

The following evaluations were performed on the resulting pattern-transferred products of Examples 33 to 38 and the pattern-formed member of Comparative Example 14.

### <Evaluation of conductivity>

The sheet resistance value of the conductive pattern of each member was measured using a measuring device (Loresta-GP from Dia Instruments Co., Ltd.). The results are as follows.
Example 33: 0.035 Ω/□
Example 34: 0.008 Ω/□
Example 35: 0.033 Ω/□
Example 36: 0.035 Ω/□
Example 37: 0.040 Ω/□
Example 38: 0.044 Ω/□
Comparative Example 14: 0.040 Ω/□

### <Evaluation of adhesion>

The adhesion of the conductive pattern of each member to the transfer-receiving body was determined by the cross-cut test specified in JIS K 5600-5-6. A portion with the conductive pattern of each member was cross-cut at 2-mm intervals to give a total of 25 squares (5 squares × 5 squares). CELLOTAPE (24 mm width) from Nichiban Co., Ltd. was attached to the portion and rapidly peeled off. Unpeeled squares were observed for evaluation. The results are as follows.
Example 33: Adhesion was good with no squares peeled off.
Example 34: Adhesion was good with no squares peeled off.
Example 35: Adhesion was good with no squares peeled off.
Example 36: Adhesion was good with no squares peeled off.
Example 37: Adhesion was good with no squares peeled off.
Example 38: Adhesion was good with no squares peeled off.
Comparative Example 14: Adhesion was poor with some squares peeled off.

### (Example 39)

A transfer sheet was produced as in Example 1, except that the conductivity developer coating solution 1 was not applied. An image pattern (50 mm × 50 mm) was printed on the transfer sheet using an inkjet printer containing a water-based pigment ink. Thus, a transfer pattern was formed on the transfer sheet.

Using a roll laminator, the pattern-formed surface of the transfer sheet was pressure-bonded to a transfer-receiving body in the form of carbon fiber reinforced resin molding prepreg (Torayca F6343B from Toray Industries, Inc.), at a roll temperature of 25°C, a pressure of 10 N/cm², and a rate of 0.3 m/min (pressure-bonding time of 1 second). Then, the transfer sheet was peeled off. Subsequently, the transfer-receiving body was heated at 140°C for 30 minutes, whereby a pattern-transferred product of Example 39 having a transfer pattern was obtained. The surface of the resulting pattern-transferred product was not adhesive at room temperature.

### (Example 40)

A transfer sheet was produced as in Example 2, except that a dissociation layer coating solution 5 having the following composition, instead of the conductivity developer coating solution 1, was applied to the porous layer used in Example 2. The amount based on the solid content of the dissociation layer formed on the porous layer was 0.04 g/m². A transfer pattern was formed on the transfer sheet as in Example 39.

### <Dissociation layer coating solution 5>

| | |
|---|---|
| 12 Mass% slurry of colloidal silica | 1.7 parts by mass |
| (Quartron PL-1 from Fuso Chemical Co., Ltd.; average primary particle size: 15 nm) | |
| Water | 98.3 parts by mass |

Using a roll laminator, the transfer pattern-formed surface of the transfer sheet was pressure-bonded to a transfer-receiving body in the form of an epoxy resin sheet (DRS-028 from Sanyu Rec Co., Ltd.), at a roll temperature of 25°C, a pressure of 10 N/cm², and a rate of 0.3 m/min (pressure-bonding time of 1 second). Then, the transfer sheet was peeled off. Subsequently, the transfer-receiving body was heated at 150°C for 60 minutes, whereby a pattern-transferred product of Example 40 having a transfer pattern was obtained. The surface of the resulting pattern-transferred product was not adhesive at room temperature.

### (Example 41)

A transfer sheet was produced as in Example 39, except that the dissociation layer coating solution 3 used in Example 3 was used instead of the dissociation layer coating solution 1 used for the transfer sheet in Example 39. The coating amount based on the solid content of the dissociation layer formed on the porous layer was 0.6 g/m². A pattern-transferred product of Example 41 was obtained as in Example 39, using the transfer sheet. The surface of the resulting pattern-transferred product was not adhesive at room temperature.

### (Example 42)

A transfer sheet was produced as in Example 39, except that the dissociation layer coating solution 4 used in Example 5 was used instead of the dissociation layer coating solution 1 used for the transfer sheet in Example 39. The coating amount based on the solid content of the dissociation layer formed on the porous layer was 0.2 g/m². A pattern-transferred product of Example 42 was obtained as in Example 39, using the transfer sheet. The surface of the resulting pattern-transferred product was not adhesive at room temperature.

### (Example 43)

A transfer pattern was formed on the transfer sheet of Example 39 by applying an ink adjustment solution 1 described below with a wire bar to a coating amount based on the moisture content of 12 g/m². A pattern-transferred product of Example 43 was obtained as in Example 39, using the transfer pattern-formed transfer sheet. The surface of the resulting pattern-transferred product was not adhesive at room temperature.

### <Ink adjustment solution 1>

| | |
|---|---|
| Ink for refill, universal ink pigment, black | 0.5 parts by mass |
| (Sogo Kigyo Service Limited., UNI-E100-BK) | |
| Acrylic emulsion | 0.37 parts by mass |
| (NeoCryl® YK-188 from Kusumoto Chemicals, Ltd.; solids concentration: 44.5 mass%) | |
| Water | 0.14 parts by mass |

### (Example 44)

A pattern-transferred product of Example 44 was obtained as in Example 43, except that an ink adjustment solution 2 described below was used instead of the ink adjustment solution 1. The surface of the resulting pattern-transferred product was not adhesive at room temperature.

### <Ink adjustment solution 2>

| | |
|---|---|
| Ink for refill, universal ink pigment, black | 0.5 parts by mass |
| (UNI-E100-BK from Sogo Kigyo Service Limited.) | |
| Acrylic emulsion | 0.25 parts by mass |
| (NeoCryl YK-188 from Kusumoto Chemicals, Ltd.) | |
| Water | 0.25 parts by mass |

### (Comparative Example 15)

A pattern-transferred product of Comparative Example 15 was obtained as in Example 39, except that a transfer sheet including only a porous layer was used which was produced without applying the dissociation layer coating solution to the porous layer. The surface of the resulting pattern-transferred product was not adhesive at room temperature.

### (Comparative Example 16)

An attempt was made to produce a pattern-transferred product of Comparative Example 16 as in Example 39, except that a transfer sheet including only a dissociation layer was used which was produced without applying the porous layer forming coating solution. However, the transfer sheet including only the dissociation layer did not absorb the solvent of the water-based pigment ink, failing to provide a satisfactory pattern-transferred product.

### (Comparative Example 17)

An attempt was made to produce a pattern-transferred product of Comparative Example 17 as in Example 39, except that the transfer-receiving body was changed to an ABS resin (ABS Sheet F-4626, black, from Sekon Industry Inc.). However, the transfer pattern was not transferred to the transfer-receiving body, failing to provide a satisfactory pattern-transferred product. The surface of the ABS resin is not adhesive at room temperature.

### (Comparative Example 18)

A pattern-transferred product of Comparative Example 18 was obtained as in Comparative Example 17, except that an optically clear double-sided acrylic adhesive film sheet (NNX50 from Gunze Limited; thickness: 50 µm; adhesive force at 25°C: 0.2 N/25 mm or more as determined at a peeling angle of 180 degrees according to JIS Z0237; non-thermally curable) was placed between the transfer sheet and the transfer-receiving body, with PET release films on both sides of the film sheet removed, and that pressure-bonding was performed using a roll laminator, at a roll temperature of 25°C, a pressure of 10 N/cm², and a rate of 0.5 m/min. The surface of the resulting pattern-transferred product was adhesive at room temperature because of the optically clear double-sided acrylic adhesive film sheet thereon.

### (Comparative Example 19)

A pattern-transferred product of Comparative Example 19 was obtained as in Example 39, except that thermal curing at 140°C of 30 minutes was not performed. The surface of the resulting pattern-transferred product was adhesive at room temperature.

### (Comparative Example 20)

Using a receptor layer transfer sheet (washing-resistant, iron print paper "JP-TPRTYN" from Sanwa Supply Inc.) instead of the transfer sheet of Example 39, an image pattern was transferred to a transfer-receiving body according to a transfer method described in instructions, followed by heating at 140°C for 30 minutes. Thus, a pattern-transferred product of Comparative Example 20 was obtained. The surface of the resulting pattern-transferred product was not adhesive at room temperature.

The following evaluations were performed on the resulting pattern-transferred products of Examples 39 to 44 and Comparative Examples 15 and 18 to 20.

### <Transferability>

The transfer quality of each pattern-transferred product was visually observed and evaluated based on the following criteria. Table 3 shows the results.
1: The pattern was transferred very clearly.
2: The pattern was transferred clearly, although slightly unclear as compared to 1 above.
3: The pattern was transferred but not clear.
4: Some portions of the pattern were not transferred.

### <Adhesion>

Elleair PROWIPE® Soft Wiper S200 (Daio Paper Corporation) was rubbed against each pattern-transferred product for 10 times back and forth. Then, the state of the pattern was visually observed and evaluated based on the following criteria. Table 3 shows the results. 1: There was no change before and after rubbing. 2: There was almost no change before and after rubbing. 3: A portion of the pattern came off and stuck to the wiper. 4: Almost the entire pattern came off.

**[Table 3]**

| | Transferability | Adhesion |
|---|---|---|
| Example 39 | 1 | 1 |
| Example 40 | 2 | 1 |
| Example 41 | 1 | 1 |
| Example 42 | 1 | 1 |
| Example 43 | 1 | 1 |
| Example 44 | 1 | 1 |
| Comparative Example 15 | 4 | 1 |
| Comparative Example 18 | 3 | 1 |
| Comparative Example 19 | 1 | 3 |
| Comparative Example 20 | 3 | 1 |

### (Example 45)

A polyamide thermoplastic resin film sheet (ELPHAN NT-120 from Nihon Matai Co., Ltd.; thickness: 50 µm) as a heat-sensitive adhesive material was placed between a transfer-receiving body in the form of a plain-woven cotton fabric made with a 50 denier yarn and the transfer pattern-formed surface of the pattern-formed transfer sheet produced in Example 39. Pressure-bonding was performed using a roll laminator at a roll temperature of 110°C, a pressure of 10 N/cm², and a rate of 0.5 m/min. After naturally cooling to room temperature, the transfer sheet was peeled off. Thus, a pattern-transferred product of Example 45 having a transfer pattern was obtained. The surface of the resulting pattern-transferred product was not adhesive at room temperature. The polyamide thermoplastic resin film sheet having a width of 25 mm had an adhesive force of 0.2 to 10 N/25 mm when heated to 110°C and an adhesive force of less than 0.1 N/25 mm at room temperature, as measured at a peeling angle of 180 degrees according to JIS Z 0237.

### (Example 46)

A pattern-transferred product of Example 46 was obtained as in Example 45, except that the pattern-formed transfer sheet was the pattern-formed transfer sheet produced in Example 40. The surface of the resulting pattern-transferred product was not adhesive at room temperature.

### (Example 47)

A pattern-transferred product of Example 47 was obtained as in Example 45, except that the heat-sensitive adhesive material of Example 45 was changed to a polyurethane thermoplastic resin film sheet (ELPHAN UH-203 from Nihon Matai Co., Ltd.; thickness: 50 µm). The surface of the resulting pattern-transferred product was not adhesive at room temperature. The polyurethane thermoplastic resin film sheet having a width of 25 mm had an adhesive force of 0.2 to 10 N/25 mm when heated to 110°C and an adhesive force of less than 0.1 N/25 mm at room temperature, as measured at a peeling angle of 180 degrees according to JIS Z 0237.

### (Example 48)

A polyamide thermoplastic resin film sheet (ELPHAN NT-120 from Nihon Matai Co., Ltd.) as a heat-sensitive adhesive material was placed between a transfer-receiving body in the form of a 5 mm-thick polyethylene terephthalate (PET) resin plate and the transfer pattern-formed surface of the pattern-formed transfer sheet produced in Example 1. Pressure-bonding was performed using a roll laminator at a roll temperature of 110°C, a pressure of 10 N/cm², and a rate of 0.5 m/min. After naturally cooling to room temperature, the transfer sheet was peeled off. Thus, a pattern-transferred product of Example 48 having a transfer pattern was obtained. The surface of the resulting pattern-transferred product was not adhesive at room temperature.

The sheet resistance value of the conductive pattern transferred to the pattern-transferred product was measured using a measuring device (Loresta-GP from Dia Instruments Co., Ltd.). The sheet resistance value was 0.150 Ω/□. Since the transfer pattern of the pattern-transferred product was a metallic pattern with metallic gloss, the pattern-transferred product was also usable as a metallic decorative member.

### (Example 49)

A pattern-transferred product of Example 49 was obtained as in Example 45, except that the pattern-formed transfer sheet was the pattern-formed transfer sheet produced in Example 41. The surface of the resulting pattern-transferred product was not adhesive at room temperature.

### (Example 50)

A pattern-transferred product of Example 50 was obtained as in Example 45, except that the pattern-formed transfer sheet was the pattern-formed transfer sheet produced in Example 42. The surface of the resulting pattern-transferred product was not adhesive at room temperature.

### (Example 51)

The pattern-formed transfer sheet was the pattern-formed transfer sheet produced in Example 43. Using a roll laminator, the transfer pattern-formed surface of the transfer sheet was pressure-bonded to a transfer-receiving body in the form of a plain-woven polyester fabric made with a 50 denier yarn, at a roll temperature of 140°C, a pressure of 10 N/cm², and a rate of 0.5 m/min. After naturally cooling to room temperature, the transfer sheet was peeled off. Thus, a pattern-transferred product of Example 51 having a transfer pattern was obtained. The surface of the resulting pattern-transferred product was not adhesive at room temperature. The transfer pattern in the form of a dry film having a width of 25 mm had an adhesive force of 0.2 to 10 N/25 mm when heated to 140°C and an adhesive force of less than 0.1 N/25 mm at room temperature, as measured at a peeling angle of 180 degrees according to JIS Z 0237.

### (Example 52)

A pattern-transferred product of Example 52 was obtained as in Example 51, except that the pattern-formed transfer sheet was the pattern-formed transfer sheet produced in Example 44. The surface of the resulting pattern-transferred product was not adhesive at room temperature. The transfer pattern in the form of a dry film having a width of 25 mm had an adhesive force of 0.2 to 10 N/25 mm when heated to 140°C and an adhesive force of less than 0.1 N/25 mm at room temperature (ordinary temperature), as measured at a peeling angle of 180 degrees according to JIS Z 0237.

### (Comparative Example 21)

A pattern-transferred product of Comparative Example 21 was obtained as in Example 45, except that a transfer sheet including only a porous layer was used which was produced without applying the dissociation layer coating solution to the porous layer. The surface of the resulting pattern-transferred product was not adhesive at room temperature.

### (Comparative Example 22)

An attempt was made to produce a pattern-transferred product of Comparative Example 22 as in Example 45, except that a transfer sheet including only a dissociation layer was used which was produced without applying the porous layer forming coating solution. However, the transfer sheet including only the dissociation layer did not absorb the solvent of the water-based pigment ink, failing to provide a satisfactory pattern-transferred product.

### (Comparative Example 23)

A pattern-transferred product of Comparative Example 23 was obtained as in Example 45, except that an optically clear double-sided acrylic adhesive film sheet (NNX50 from Gunze Limited), with PET release films on both sides of the film sheet removed, was used instead of the polyamide thermoplastic resin film sheet, and that pressure-bonding was performed using a roll laminator, at a roll temperature of 25°C, a pressure of 10 N/cm², and a rate of 0.5 m/min. The surface of the resulting pattern-transferred product was adhesive at room temperature because of the optically clear double-sided acrylic adhesive film sheet thereon.

### (Comparative Example 24)

Using a receptor layer transfer sheet (washing-resistant, iron print paper "JP-TPRTYN" from Sanwa Supply Inc.) instead of the transfer sheet of Example 45, an image pattern was transferred to a transfer-receiving body according to a transfer method described in instructions. Thus, a pattern-transferred product of Comparative Example 24 was obtained. The surface of the resulting pattern-transferred product was not adhesive at room temperature.

The resulting pattern-transferred products of Examples 45 to 52 and Comparative Examples 21, 23, and 24 were evaluated in the same manner as in the pattern-transferred products of Examples 39 to 44 and Comparative Examples 15 and 18 to 20. Table 4 shows the results.

**[Table 4]**

| | Transferability | Adhesion |
|---|---|---|
| Example 45 | 1 | 1 |
| Example 46 | 2 | 1 |
| Example 47 | 2 | 2 |
| Example 48 | 1 | 2 |
| Example 49 | 1 | 1 |
| Example 50 | 1 | 1 |
| Example 51 | 1 | 2 |
| Example 52 | 2 | 2 |
| Comparative Example 21 | 4 | 1 |
| Comparative Example 23 | 2 | 3 |
| Comparative Example 24 | 3 | 1 |

### (Example 53)

A porous layer forming coating solution 3 having the following composition was produced. The porous layer forming coating solution 3 was applied with a slide bead coater to a 100-µm thick, easy-adhesion treated polyethylene terephthalate film (Teijin Film Solutions Limited) serving as a support to a coating amount after drying of the porous layer of 34.5 g/m², followed by drying, whereby a porous layer was formed. The porous layer contained a total of 5 mass% of glycerol and diglycerol relative to the total solid content of the porous layer.

### <Porous layer forming coating solution 3>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%, average degree of polymerization: 3500, molecular weight: about 150000) | |
| Boric acid | 0.4 parts by mass |
| Nonionic surfactant | 0.3 parts by mass |
| (polyoxyethylene alkyl ether) | |
| Diglycerol | 6.0 parts by mass |
| (Diglycerin S from Sakamoto Yakuhin Kogyo Co., Ltd., containing 0.9 mass% glycerol and 95.4 mass% diglycerol) | |

Water was added to adjust the concentration of components excluding water to 17 mass%.

Then, a conductivity developer coating solution 2 was applied to the porous layer surface by a coating method using a tri-helical gravure roll, followed by drying with a dryer. The tri-helical gravure roll used was a gravure roll having a diameter of 60 mm, 90 lines per inch with a groove angle of 45 degrees, and a groove depth of 110 µm, and was used in reverse rotation. The coating amount based on the moisture content was set to 20 g/m² by adjusting the rotating speed of the tri-helical gravure roll. The applied conductivity developer coating solution was absorbed into the porous layer, and the porous layer was exposed at the surface.

### <Conductivity developer coating solution 2>

| | |
|---|---|
| Sodium chloride | 0.6 parts by mass |
| Water | 99.4 parts by mass |

Further, the dissociation layer coating solution 1 used in Example 1 was applied and dried as in Example 1 to obtain a transfer sheet, and a conductive pattern was produced on the transfer sheet as in Example 1.

Using a roll laminator, the conductive pattern-formed surface of the transfer sheet was pressure-bonded to a transfer-receiving body in the form of a polyimide coverlay film (CMA 1025 KA from Arisawa Manufacturing Co., Ltd., including an epoxy resin layer (thermosetting resin) on a polyimide film), at a roll temperature of 110°C, a pressure of 10 N/cm², and a rate of 0.3 m/min (pressure-bonding time of 1 second). Then, the transfer sheet was peeled off. Subsequently, the transfer-receiving body was heated at 160°C for 60 minutes, whereby a pattern-transferred product of Example 53 having a conductive pattern was obtained. The surface of the resulting pattern-transferred product was not adhesive at room temperature. The polyimide coverlay film having a width of 25 mm had an adhesive force of 0.2 to 10 N/25 mm when heated to 110°C and an adhesive force of less than 0.1 N/25 mm at room temperature, as measured at a peeling angle of 180 degrees according to JIS Z 0237.

### (Example 54)

A pattern-transferred product of Example 54 having a conductive pattern was obtained as in Example 53, except that the porous layer was formed by applying a porous layer forming coating solution 4 having the following composition, instead of the porous layer forming coating solution 3 of Example 53, to a coating amount after drying of the porous layer of 36.5 g/m². The surface of the resulting pattern-transferred product was not adhesive at room temperature. The porous layer contained a total of 10 mass% of glycerol and diglycerol relative to the total solid content of the porous layer.

### <Porous layer forming coating solution 4>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Diglycerol (Diglycerin S from Sakamoto Yakuhin Kogyo Co., Ltd.) | 12.7 parts by mass |

Water was added to adjust the concentration of components excluding water to 18 mass%.

### (Example 55)

A pattern-transferred product of Example 55 having a conductive pattern was obtained as in Example 53, except that the porous layer was formed by applying a porous layer forming coating solution 5 having the following composition, instead of the porous layer forming coating solution 3 of Example 53, to a coating amount after drying of the porous layer of 38.6 g/m². The surface of the resulting pattern-transferred product was not adhesive at room temperature. The porous layer contained a total of 15 mass% of glycerol and diglycerol relative to the total solid content of the porous layer.

### <Porous layer forming coating solution 5>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Diglycerol (Diglycerin S from Sakamoto Yakuhin KogyoCo., Ltd.) | 20.1 parts by mass |

Water was added to adjust the concentration of components excluding water to 19 mass%.

### (Example 56)

A pattern-transferred product of Example 56 having a conductive pattern was obtained as in Example 53, except that the porous layer was formed by applying a porous layer forming coating solution 6 having the following composition, instead of the porous layer forming coating solution 3 of Example 53, to a coating amount after drying of the porous layer of 41.0 g/m². The surface of the resulting pattern-transferred product was not adhesive at room temperature. The porous layer contained a total of 20 mass% of glycerol and diglycerol relative to the total solid content of the porous layer.

### <Porous layer forming coating solution 6>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Diglycerol (Diglycerin S from Sakamoto Yakuhin Kogyo Co., Ltd.) | 28.5 parts by mass |

Water was added to adjust the concentration of components excluding water to 20 mass%.

### (Example 57)

A pattern-transferred product of Example 57 having a conductive pattern was obtained as in Example 53, except that the porous layer was formed by applying a porous layer forming coating solution 7 having the following composition, instead of the porous layer forming coating solution 3 of Example 53, to a coating amount after drying of the porous layer of 38.6 g/m². The surface of the resulting pattern-transferred product was not adhesive at room temperature. The porous layer contained 15 mass% of glycerol relative to the total solid content of the porous layer.

### <Porous layer forming coating solution 7>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Glycerol | 20.4 parts by mass |
| (Glycerol from Showa Chemical Industry Co., Ltd., containing 95 mass% glycerol) | |

Water was added to adjust the concentration of components excluding water to 19 mass%.

### (Example 58)

A pattern-transferred product of Example 58 having a conductive pattern was obtained as in Example 53, except that the porous layer was formed by applying a porous layer forming coating solution 8 having the following composition, instead of the porous layer forming coating solution 3 of Example 53, to a coating amount after drying of the porous layer of 38.6 g/m². The surface of the resulting pattern-transferred product was not adhesive at room temperature. The porous layer contained a total of 15 mass% of glycerol and polyglycerol relative to the total solid content of the porous layer.

### <Porous layer forming coating solution 8>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Polyglycerol (degree of polymerization: 4) | 20.5 parts by mass |
| (Polyglycerin #310 from Sakamoto Yakuhin Kogyo Co., Ltd., containing 7.3 mass% glycerol and 87.2 mass% polyglycerol) | |

Water was added to adjust the concentration of components excluding water to 19 mass%.

### (Example 59)

A pattern-transferred product of Example 59 having a conductive pattern was obtained as in Example 53, except that the porous layer was formed by applying a porous layer forming coating solution 9 having the following composition, instead of the porous layer forming coating solution 3 of Example 53, to a coating amount after drying of the porous layer of 38.6 g/m². The surface of the resulting pattern-transferred product was not adhesive at room temperature. The porous layer contained a total of 15 mass% of glycerol, diglycerol, and polyglycerol relative to the total solid content of the porous layer.

### <Porous layer forming coating solution 9>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant (polyoxyethylene alkyl ether) | 0.3 parts by mass |
| Polyglycerol (degree of polymerization: 6) | 21.5 parts by mass |
| (Polyglycerin #500 from Sakamoto Yakuhin Kogyo Co., Ltd., containing 0.1 mass% glycerol, 3.6 mass% diglycerol, and 86.2 mass% polyglycerol) | |

Water was added to adjust the concentration of components excluding water to 19 mass%.

### (Example 60)

A pattern-transferred product of Example 60 having a conductive pattern was obtained as in Example 53, except that the porous layer was formed by applying a porous layer forming coating solution 10 having the following composition, instead of the porous layer forming coating solution 3 of Example 53, to a coating amount after drying of the porous layer of 38.6 g/m². The surface of the resulting pattern-transferred product was not adhesive at room temperature. The porous layer contained a total of 15 mass% of glycerol and polyglycerol relative to the total solid content of the porous layer.

### <Porous layer forming coating solution 10>

| | |
|---|---|
| Inorganic fine particle dispersion 2 | 100 parts by mass |
| (in terms of alumina hydrate solid content) | |
| Polyvinyl alcohol | 9 parts by mass |
| (degree of saponification: 88%; average degree of polymerization: 3500; molecular weight: about 150000) | |
| Boric acid | 0.4 parts by mass |
| Nonionic surfactant | 0.3 parts by mass |
| (polyoxyethylene alkyl ether) | |
| Polyglycerol (degree of polymerization: 10) | 21.5 parts by mass |
| (Polyglycerin #750 from Sakamoto Yakuhin Kogyo Co., Ltd., containing 1.1 mass% glycerol and 88.9 mass% polyglycerol) | |

Water was added to adjust the concentration of components excluding water to 19 mass%.

### (Example 61)

A pattern-transferred product of Example 61 having a conductive pattern was obtained as in Example 53, except that the porous layer was formed by applying a porous layer forming coating solution 2 used in Example 2, instead of the porous layer forming coating solution 3 of Example 53, to a coating amount after drying of the porous layer of 32.8 g/m². The surface of the resulting pattern-transferred product was not adhesive at room temperature.

### (Example 62)

A 50 mm x 50 mm solid black pattern was printed on the transfer sheet produced in Example 55 to form a transfer pattern on the transfer sheet, using an inkjet printer for pigment ink (OfficeJet Pro 6230 from Hewlett-Packard).

A polyamide thermoplastic resin film sheet (ELPHAN NT-120 from Nihon Matai Co., Ltd.) as a heat-sensitive adhesive material was placed between a transfer-receiving body in the form of a plain-woven cotton fabric made with a 50-denier yarn and the transfer pattern-formed surface of the pattern-formed transfer sheet. Pressure-bonding was performed using a roll laminator at a roll temperature of 110°C, a pressure of 10 N/cm², and a rate of 0.5 m/min. After naturally cooling to room temperature, the transfer sheet was peeled off. Thus, a pattern-transferred product of Example 62 having a transfer pattern was obtained. The surface of the resulting pattern-transferred product was not adhesive at room temperature.

### (Example 63)

A pattern-transferred product of Example 63 was obtained as in Example 62, except that the transfer sheet was the transfer sheet produced in Example 61. The surface of the resulting pattern-transferred product was not adhesive at room temperature.

Twenty pattern-transferred products were produced in each of Examples 53 to 63. Then, the following evaluations were performed.

### <Evaluation of contamination on pattern-transferred surface of pattern-transferred product>

Out of 20 pattern-transferred products, the percentage of the number of pattern-transferred products was determined in which a stack of the porous layer and the dissociation layer formed on the support of transfer sheet was partially peeled off from the support and transferred to the transfer-receiving body to cause contamination on the pattern-transferred surface. The results are as follows.
Example 53: The percentage of contaminated products was 10% or more and less than 30%.
Example 54: The percentage of contaminated products was 5% or more and less than 10%.
Example 55: The percentage of contaminated products was 0%.
Example 56: The percentage of contaminated products was 0%.
Example 57: The percentage of contaminated products was 0%.
Example 58: The percentage of contaminated products was 0%.
Example 59: The percentage of contaminated products was 0%.
Example 60: The percentage of contaminated products was 5% or more and less than 10%.
Example 61: The percentage of contaminated products was 30% or more.
Example 62: The percentage of contaminated products was 5% or more and less than 10%.
Example 63: The percentage of contaminated products was 30% or more.

The above results show that the method of producing a pattern-transferred product with simple steps of the present invention can produce pattern-transferred products each having good adhesion between a transferred pattern and a transfer-receiving body.

### REFERENCE SIGNS LIST

1 Support
2 Porous layer
3 Dissociation layer
4 Transfer pattern
5 Transfer-receiving body
6 Material that becomes adhesive when heated (heat-sensitive adhesive material)
7 Plating layer
10 Transfer sheet

## Claims

1. A method of producing a pattern-transferred product, at least comprising:
a step of forming a transfer pattern on a dissociation layer of a transfer sheet including at least a porous layer on a support and the dissociation layer on the porous layer;
a transferring step, the step being selected from a step of transferring the transfer pattern to a transfer-receiving body having an adhesive surface or a step of transferring the transfer pattern to a transfer-receiving body via an adhesive material; and
a step of removing adhesion from the surface of the transfer-receiving body or from the adhesive material.

2. The method of producing the pattern-transferred product according to claim 1,
wherein the transfer-receiving body having an adhesive surface is a transfer-receiving body that is adhesive at room temperature, and the step of removing adhesion from the surface of the transfer-receiving body is a step of thermally curing the transfer-receiving body.

3. The method of producing a pattern-transferred product according to claim 1,
wherein the transfer-receiving body having an adhesive surface is a transfer-receiving body that is not adhesive at room temperature and that becomes adhesive when heated, and the step of removing adhesion from the surface of the transfer-receiving body is a step of thermally curing the transfer-receiving body.

4. The method of producing a pattern-transferred product according to claim 1,
wherein the transfer-receiving body having an adhesive surface is a transfer-receiving body that is not adhesive at room temperature and that becomes adhesive when heated, and the step of removing adhesion from the surface of the transfer-receiving body is a step of naturally cooling the transfer-receiving body to room temperature.

5. The method of producing a pattern-transferred product according to claim 1,
wherein the adhesive material is a material that is not adhesive at room temperature and that becomes adhesive when heated, and the step of removing adhesion from the adhesive material is a step of naturally cooling the transfer-receiving body to room temperature.

6. The method of producing a pattern-transferred product according to any one of claims 1 to 5,
wherein the transfer pattern is a pattern selected from a conductive pattern, a metallic pattern, or a pattern printed with pigment inks.

7. The method of producing a pattern-transferred product according to claim 2 or 3,
wherein the transfer pattern is a conductive pattern, and the method includes, after the transferring step, a step of plating the transferred conductive pattern, and subsequently includes the step of removing adhesion from the surface of the transfer-receiving body.

8. The method of producing a pattern-transferred product according to claim 4,
wherein the transfer pattern is a conductive pattern, and the method includes, after the step of removing adhesion from the surface of the transfer-receiving body, a step of plating the transferred conductive pattern.

9. The method of producing a pattern-transferred product according to any one of claims 1 to 8,
wherein the porous layer contains at least one compound selected from glycerol or polyglycerol.
